# EUROPEAN PATENT APPLICATION

(11) **EP 4 561 288 A1**
(43) Date of publication of application: **28.05.2025**
(21) Application number: 24182800.3
(22) Date of filing: 18.06.2024
(51) Int. Cl.: H10B 10/00, H01L 23/528, H01L 27/06, H01L 29/06, H01L 29/775, H01L 21/8238

(54) **SEMICONDUCTOR DEVICE**

(30) Priority: 21.11.2023 KR 20230162686
(71) Applicant: Samsung Electronics Co., Ltd., Suwon-si, Gyeonggi-do 16677 (KR)
(72) Inventor: KIM, Jeewoong, 16677 Suwon-si, Gyeonggi-do (KR); LEE, Kyo-Wook, 16677 Suwon-si, Gyeonggi-do (KR); LEE, Seunghun, 16677 Suwon-si, Gyeonggi-do (KR); CHO, Keun Hwi, 16677 Suwon-si, Gyeonggi-do (KR)
(74) Representative: Kuhnen & Wacker Patent- und Rechtsanwaltsbüro PartG mbB

(57) **Abstract**

A semiconductor device may include a first lower active contact, a first source/drain pattern on the first lower active contact, a second lower active contact, a second source/drain pattern on the second lower active contact, a lower conductive layer electrically connected to the first and second lower active contacts, a third source/drain pattern and a fourth source/drain pattern between the first and second source/drain patterns, a first upper active contact on the third source/drain pattern, a second upper active contact on the fourth source/drain pattern, and an upper conductive line electrically connected to the first and second upper active contacts. The first to fourth source/drain patterns, the first and second lower active contacts, and the first and second upper active contacts may be disposed between the lower conductive layer and upper conductive line.

## Description

### CROSS-REFERENCE TO RELATED APPLICATIONS

This U.S. non-provisional patent application claims priority under 35 U.S.C. §119 to Korean Patent Application No. 10-2023-0162686, filed on November 21, 2023, in the Korean Intellectual Property Office, the entire contents of which are hereby incorporated by reference.

### BACKGROUND OF THE INVENTION

The present disclosure relates to a semiconductor device, and in particular, to a semiconductor device including a static random-access memory (SRAM) cell.

Due to their small-sized, multifunctional, and/or low-cost characteristics, semiconductor devices are being esteemed as important elements in the electronics industry. The semiconductor devices are classified into a semiconductor memory device for storing data, a semiconductor logic device for processing data, and a hybrid semiconductor device including both of memory and logic elements. As the electronics industry is highly developed, there is an increasing demand for semiconductor devices with improved characteristics. For example, there is an increasing demand for semiconductor devices with high reliability, high performance, and/or multiple functions. To satisfy these technical requirements, complexity and/or integration density of semiconductor devices are being increased.

### SUMMARY

This disclosure provides a semiconductor device with improved electrical and reliability characteristics and a method of fabricating the same.

A semiconductor device may include a first lower active contact, a first source/drain pattern on the first lower active contact, a second lower active contact, a second source/drain pattern on the second lower active contact, a lower conductive layer electrically connected to the first and second lower active contacts, a third source/drain pattern and a fourth source/drain pattern between the first and second source/drain patterns, a first upper active contact on the third source/drain pattern, a second upper active contact on the fourth source/drain pattern, and an upper conductive line electrically connected to the first and second upper active contacts. The first to fourth source/drain patterns, the first and second lower active contacts, and the first and second upper active contacts may be disposed between the lower conductive layer and upper conductive line.

A semiconductor device may include a first source/drain pattern, a first lower active contact in contact with a lower portion of the first source/drain pattern, a second source/drain pattern, a second lower active contact in contact with a lower portion of the second source/drain pattern, a lower conductive layer electrically connected to the first and second lower active contacts, a third source/drain pattern, a first upper active contact in contact with an upper portion of the third source/drain pattern, an upper conductive line electrically connected to the upper active contact, a fourth source/drain pattern, a second upper active contact in contact with an upper portion of the fourth source/drain pattern, and a first bit line electrically connected to the second upper active contact. The lower conductive layer may include a first lower conductive portion in contact with the first lower active contact, a second lower conductive portion in contact with the second lower active contact, and a third lower conductive portion connecting the first and second lower conductive portions to each other. The first lower conductive portion may be overlapped with the first bit line, and the third lower conductive portion may be overlapped with the upper conductive line.

A semiconductor device may include a first lower insulating layer, a first word line and a second word line provided in the first lower insulating layer and extended in a first direction, a second lower insulating layer on the first lower insulating layer, a first word line connection contact and a second word line connection contact in the second lower insulating layer, a first lower conductive pattern on the first word line connection contact, a second lower conductive pattern on the second word line connection contact, a first insulating pattern surrounding the first lower conductive pattern, a second insulating pattern surrounding the second lower conductive pattern, a lower conductive layer on the second lower insulating layer, a first lower active contact on the lower conductive layer, a first source/drain pattern on the first lower active contact, a second lower active contact on the lower conductive layer, a second source/drain pattern on the second lower active contact, a first lower gate contact on the first lower conductive pattern, a first gate electrode on the first lower gate contact, a second lower gate contact on the second lower conductive pattern, a second gate electrode on the second lower gate contact, a third source/drain pattern adjacent to the first gate electrode, a first upper active contact on the third source/drain pattern, a first bit line electrically connected to the first upper active contact, a fourth source/drain pattern adjacent to the second gate electrode, a second upper active contact on the fourth source/drain pattern, a second bit line electrically connected to the second upper active contact, a fifth source/drain pattern adjacent to the first source/drain pattern in the first direction, a third upper active contact on the fifth source/drain pattern, a sixth source/drain pattern adjacent to the second source/drain pattern in the first direction, a fourth upper active contact on the sixth source/drain pattern, and an upper conductive line electrically connected to the third and fourth upper active contacts.

### BRIEF DESCRIPTION OF THE DRAWINGS

FIG. 1 is an equivalent circuit diagram illustrating an example static random-access memory (SRAM) cell.
FIG. 2A is a plan view illustrating a word line of an example semiconductor device.
FIG. 2B is a plan view illustrating a lower conductive layer, a lower conductive pattern, and a word line connection pattern of an example semiconductor device.
FIG. 2C is a plan view illustrating a source/drain pattern, a lower active contact, an upper active contact, a lower gate contact, an upper gate contact, and a gate electrode of an example semiconductor device.
FIG. 2D is a plan view illustrating an upper conductive line and a bit line of an example semiconductor device.
FIG. 2E is a sectional view taken along a line A-A' of FIG. 2A to 2D.
FIG. 2F is a sectional view taken along a line B-B' of FIG. 2A to 2D.
FIG. 2G is a sectional view taken along a line C-C' of FIG. 2A to 2D.
FIGS. 3A, 3B, 3C, 4A, 4B, 4C, 5A, 5B, 5C, 6A, 6B, 7A, 7B, and 7C are sectional views illustrating a method of fabricating the semiconductor device of FIG. 2A to 2G.
FIGS. 8A and 8B are sectional views illustrating an example semiconductor device.
FIGS. 9A and 9B are sectional views illustrating an example semiconductor device.
FIG. 10A is a plan view illustrating a word line of an example semiconductor device.
FIG. 10B is a plan view illustrating a lower conductive layer, a lower conductive pattern, and a word line connection pattern of an example semiconductor device.
FIG. 10C is a plan view illustrating a source/drain pattern, a lower active contact, upper active contact, a lower gate contact, an upper gate contact, and a gate electrode of an example semiconductor device.
FIG. 10D is a plan view illustrating an upper conductive line, a bit line, a read word line, and a read bit line of a semiconductor device.
FIG. 11A is a plan view illustrating a word line, a dummy line, and a read word line of a semiconductor device.
FIG. 11B is a plan view illustrating a lower conductive layer, a lower conductive pattern, and a word line connection pattern of an example semiconductor device.
FIG. 11C is a plan view illustrating a source/drain pattern, a lower active contact, an upper active contact, a lower gate contact, an upper gate contact, and a gate electrode of an example semiconductor device.
FIG. 11D is a plan view illustrating an upper conductive line, a bit line, a read word line, a read bit line, and a dummy pattern of an example semiconductor device.

### DETAILED DESCRIPTION

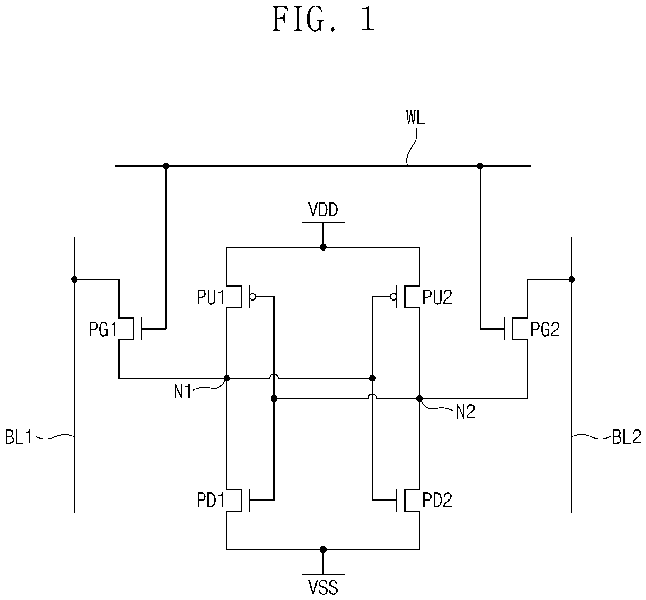

FIG. 1 is an equivalent circuit diagram illustrating a static random-access memory (SRAM) cell.

Referring to FIG. 1, the SRAM cell may include a first pull-up transistor PU1, a first pull-down transistor PD1, a second pull-up transistor PU2, a second pull-down transistor PD2, a first pass-gate transistor PG1, and a second pass-gate transistor PG2. In an implementation, the first and second pull-up transistors PU1 and PU2 may be PMOS transistors, and the first and second pull-down transistors PD1 and PD2 and the first and second pass-gate transistors PG1 and PG2 may be NMOS transistors. In an implementation, the first and second pull-up transistors PU1 and PU2 and the first and second pass-gate transistors PG1 and PG2 may be PMOS transistors, and the first and second pull-down transistors PD1 and PD2 may be NMOS transistors.

A first source/drain electrode of the first pull-up transistor PU1 and a first source/drain electrode of the first pull-down transistor PD1 may be connected to a first node N1. A source/drain electrode can include either a source electrode of a transistor or a drain electrode of a transistor. In some implementations, the same source/drain electrode may be a source electrode of one transistor and a drain electrode of another transistor. A second source/drain electrode of the first pull-up transistor PU1 may be connected to a power line VDD, and a second source/drain electrode of the first pull-down transistor PD1 may be connected to a ground line VSS. A gate electrode of the first pull-up transistor PU1 and a gate electrode of the first pull-down transistor PD1 may be electrically connected to each other. The first pull-up transistor PU1 and the first pull-down transistor PD1 may constitute a first inverter. The gate electrodes of the first pull-up and pull-down transistors PU1 and PD1, which are connected to each other, may correspond to an input node of a first inverter, and the first node N1 may correspond to an output node of the first inverter.

A first source/drain electrode of the second pull-up transistor PU2 and a first source/drain electrode of the second pull-down transistor PD2 may be connected to a second node N2. A second source/drain electrode of the second pull-up transistor PU2 may be connected to the power line VDD, and a second source/drain electrode of the second pull-down transistor PD2 may be connected to the ground line VSS. A gate electrode of the second pull-up transistor PU2 and a gate electrode of the second pull-down transistor PD2 may be electrically connected to each other. The second pull-up transistor PU2 and the second pull-down transistor PD2 may constitute a second inverter. The gate electrodes of the second pull-up and pull-down transistors PU2 and PD2, which are connected to each other, may correspond to an input node of a second inverter, and the second node N2 may correspond to an output node of the second inverter.

The first and second inverters may be combined to form a latch structure. For example, the gate electrodes of the first pull-up and pull-down transistors PU1 and PD1 may be electrically connected to the second node N2, and the gate electrodes of the second pull-up and pull-down transistors PU2 and PD2 may be electrically connected to the first node N1. A first source/drain electrode of the first pass-gate transistor PG1 may be connected to the first node N1, and a second source/drain electrode of the first pass-gate transistor PG1 may be connected to a first bit line BL1. A first source/drain electrode of the second pass-gate transistor PG2 may be connected to the second node N2, and a second source/drain electrode of the second pass-gate transistor PG2 may be connected to a second bit line BL2. Gate electrodes of the first and second pass-gate transistors PG1 and PG2 may be electrically coupled to a word line WL.

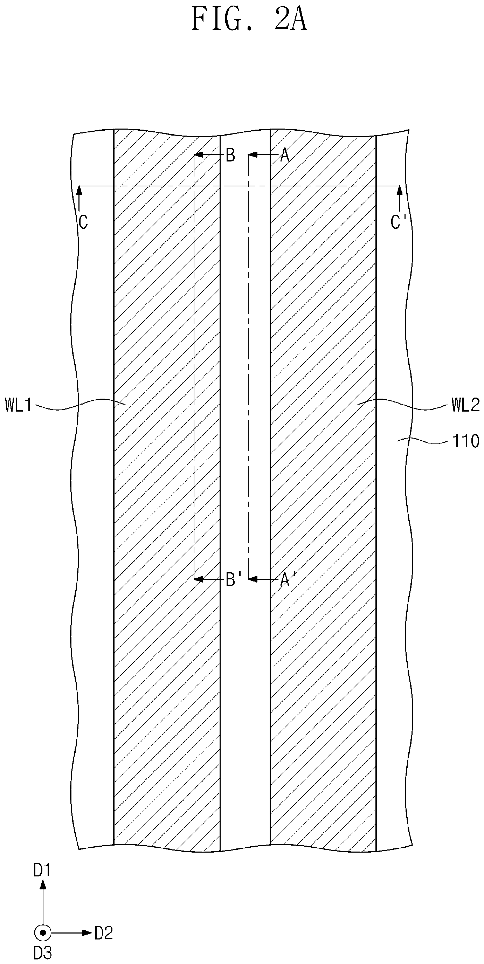

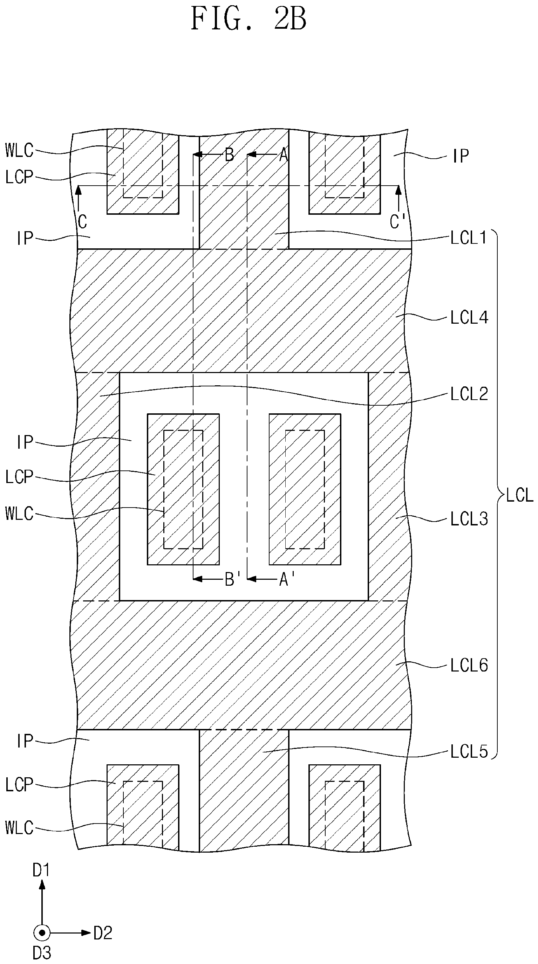

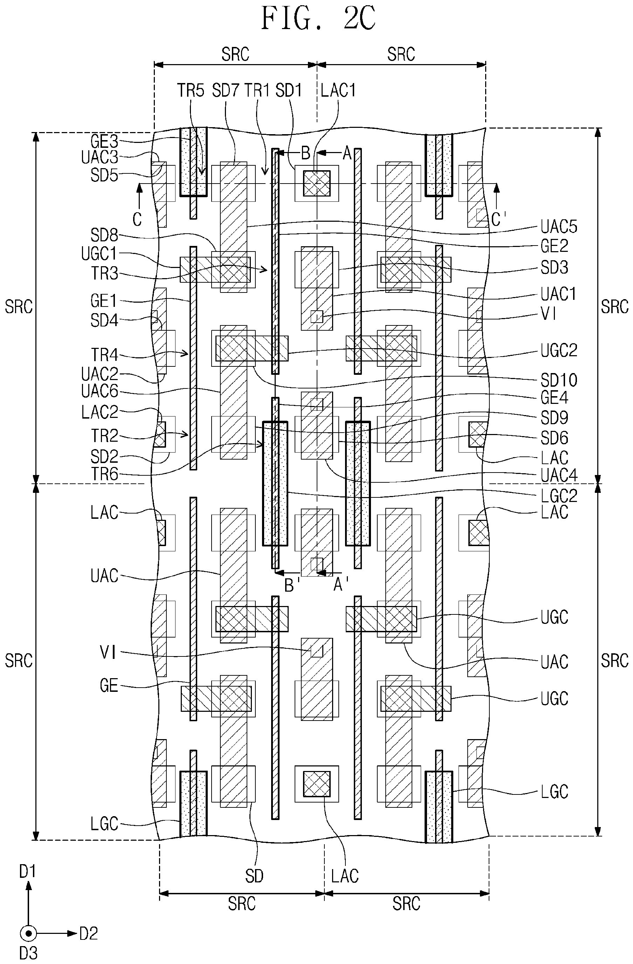

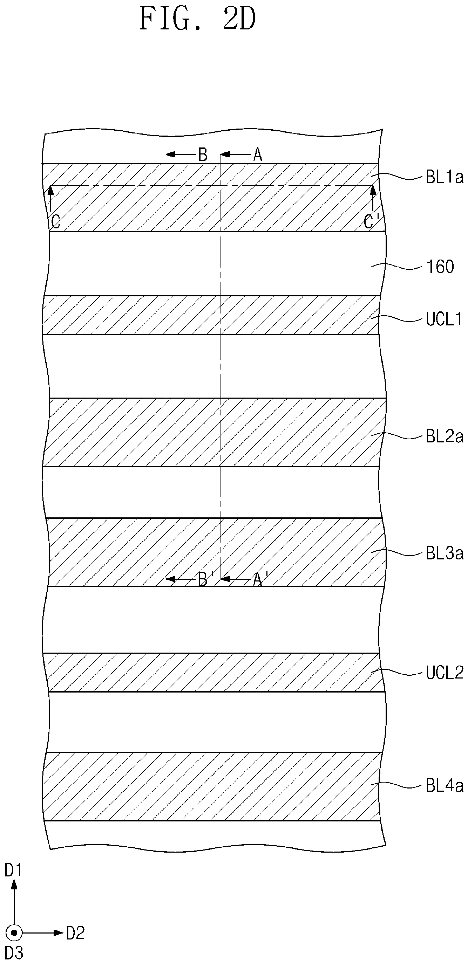

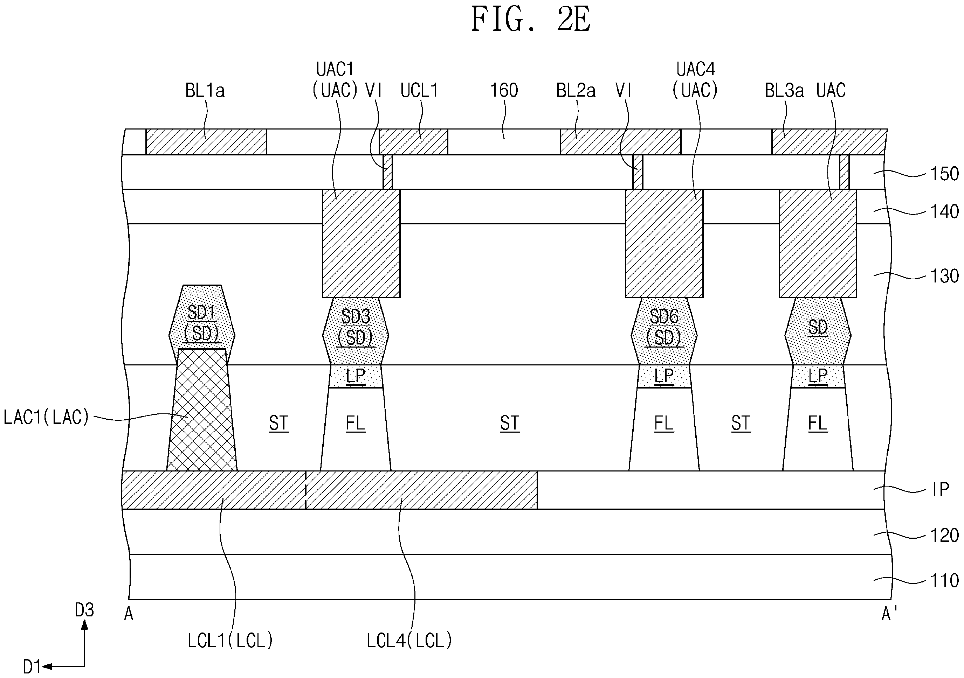

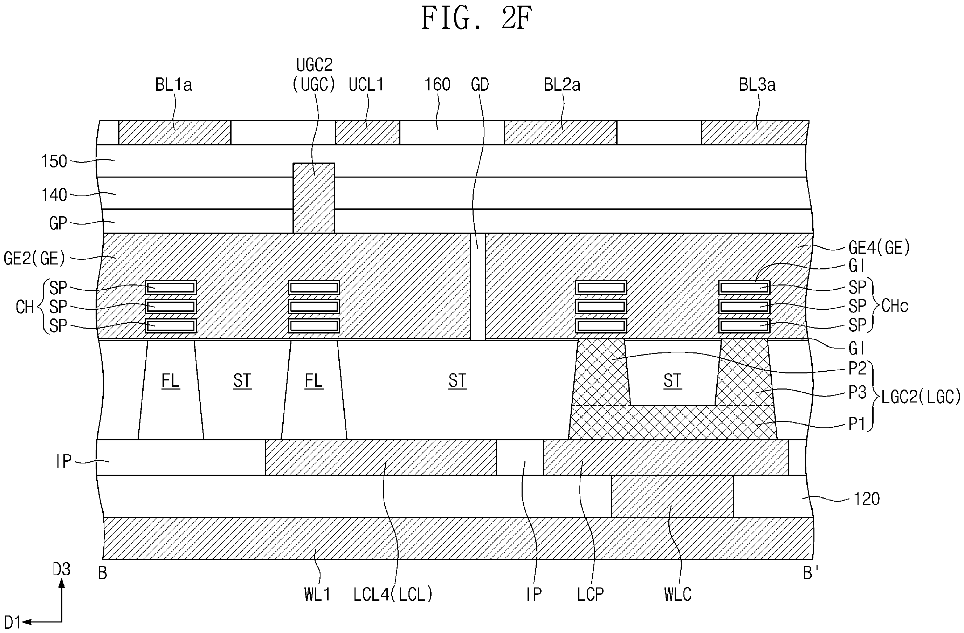

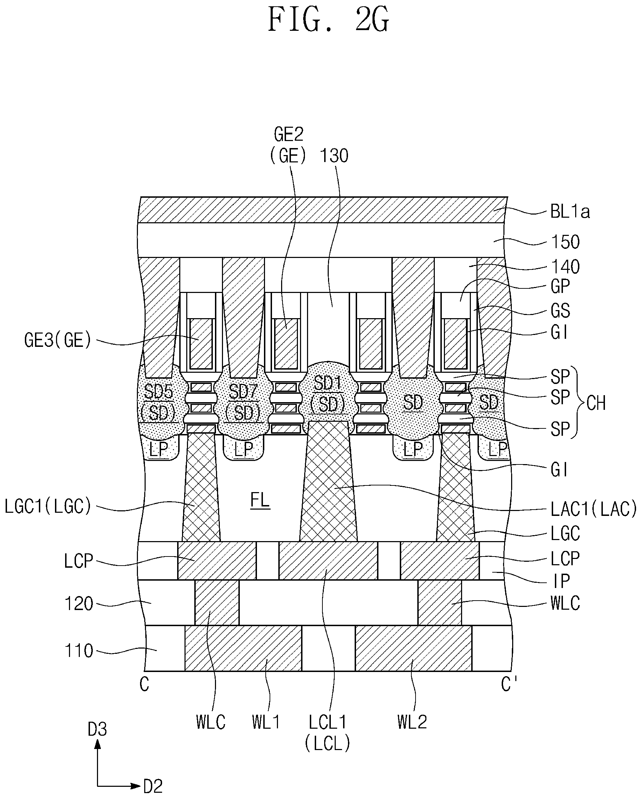

FIG. 2A is a plan view illustrating a word line of a semiconductor device. FIG. 2B is a plan view illustrating a lower conductive layer, a lower conductive pattern, and a word line connection pattern of a semiconductor device. FIG. 2C is a plan view illustrating a source/drain pattern, a lower active contact, an upper active contact, a lower gate contact, an upper gate contact, and a gate electrode of a semiconductor device. FIG. 2D is a plan view illustrating an upper conductive line and a bit line of a semiconductor device. FIG. 2E is a sectional view taken along a line A-A' of FIG. 2A to 2D. FIG. 2F is a sectional view taken along a line B-B' of FIG. 2A to 2D. FIG. 2G is a sectional view taken along a line C-C' of FIG. 2A to 2D.

Referring to FIGS. 2A to 2G, the semiconductor device may include a first lower insulating layer 110. The first lower insulating layer 110 may have a plate-shaped structure that is extended parallel to a first direction D1 and a second direction D2. The first and second directions D1 and D2 may not be parallel to each other. In an implementation, the first and second directions D1 and D2 may be horizontal directions that are orthogonal to each other. The first lower insulating layer 110 may include an insulating material.

A first word line WL1 and a second word line WL2 may be disposed in the first lower insulating layer 110. The first and second word lines WL1 and WL2 may be extended in the first direction D1. The first and second word lines WL1 and WL2 may be spaced apart from each other in the second direction D2. The first and second word lines WL1 and WL2 may include a conductive material.

A second lower insulating layer 120 may be provided on the first lower insulating layer 110. The second lower insulating layer 120 may include an insulating material.

Word line connection patterns WLC may be provided in the second lower insulating layer 120. The word line connection patterns WLC may be surrounded by the second lower insulating layer 120. A plurality of word line connection patterns WLC may be in contact with the first word line WL1. A plurality of word line connection patterns WLC may be in contact with the second word line WL2. A bottom surface of the word line connection pattern WLC may be in contact with a top surface of the first word line WL1 or a top surface of the second word line WL2. The word line connection pattern WLC may penetrate the second lower insulating layer 120 in a third direction D3. The third direction D3 may not be parallel to the first and second directions D1 and D2. In an implementation, the third direction D3 may be a vertical direction orthogonal to the first and second directions D1 and D2. The word line connection pattern WLC may include a conductive material.

A lower conductive layer LCL, lower conductive patterns LCP, and insulating patterns IP may be provided on the second lower insulating layer 120. A pair of the lower conductive patterns LCP may be surrounded by one of the insulating patterns IP. The pair of the lower conductive patterns LCP may penetrate one of the insulating pattern IP in the third direction D3. A bottom surface of the lower conductive pattern LCP may be in contact with a top surface of the word line connection pattern WLC. In an implementation, a planar area of the lower conductive pattern LCP may be larger than a planar area of the word line connection pattern WLC. The lower conductive pattern LCP may include a conductive material. The insulating pattern IP may include an insulating material.

The lower conductive layer LCL may be provided to surround the insulating patterns IP and the lower conductive patterns LCP. A bottom surface of the lower conductive layer LCL may be in contact with a top surface of the second lower insulating layer 120. The lower conductive layer LCL may include a first lower conductive portion LCL1, a second lower conductive portion LCL2, a third lower conductive portion LCL3, a fourth lower conductive portion LCL4, a fifth lower conductive portion LCL5, and a sixth lower conductive portion LCL6. The lower conductive layer LCL may include a conductive material.

The first lower conductive portion LCL1 may be disposed between the insulating patterns IP, which are adj acent to each other in the second direction D2. The second and third lower conductive portions LCL2 and LCL3 may be spaced apart from each other in the second direction D2, with the insulating pattern IP interposed therebetween. The fourth lower conductive portion LCL4 may connect the first, second, and third lower conductive portions LCL1, LCL2, and LCL3 to each other. The fourth lower conductive portion LCL4 may be extended in the second direction D2. The fourth lower conductive portion LCL4 may be disposed between the insulating patterns IP, which are adjacent to each other in the first direction D1. The fifth lower conductive portion LCL5 may be disposed between the insulating patterns IP, which are adjacent to each other in the second direction D2. The sixth lower conductive portion LCL6 may connect the second, third and fifth lower conductive portions LCL2, LCL3, and LCL5 to each other. The sixth lower conductive portion LCL6 may be extended in the second direction D2. The sixth lower conductive portion LCL6 may be disposed between the insulating patterns IP, which are adjacent to each other in the first direction D1. The fourth and sixth lower conductive portions LCL4 and LCL6 may be spaced apart from each other in the first direction D1 with the insulating pattern IP interposed therebetween. One insulating pattern IP and two lower conductive patterns LCP may be surrounded by the second, third, fourth, and sixth lower conductive portions LCL2, LCL3, LCL4, and LCL6.

A length of the fourth and sixth lower conductive portions LCL4 and LCL6 in the second direction D2 may be larger than a length of the first, second, third and fifth lower conductive portions LCL1, LCL2, LCL3, and LCL5 in the second direction D2.

For convenience in description, the lower conductive layer is described as several lower conductive portions (e.g., the first to sixth lower conductive portions LCL1, LCL2, LCL3, LCL4, LCL5, and LCL6), but the lower conductive portions (e.g., the first to sixth lower conductive portions LCL1, LCL2, LCL3, LCL4, LCL5, and LCL6) may be provided in the form of a single object without any interface therebetween.

Lower active contacts LAC may be provided on the lower conductive layer LCL. A bottom surface of the lower active contact LAC may be in contact with a top surface of the lower conductive layer LCL. A width of the lower active contact LAC may decrease as a vertical level increases. The width of the lower active contact LAC may decrease as a distance from the lower conductive layer LCL increases. The lower active contact LAC may include a conductive material.

Filling insulating layers FL may be provided. The filling insulating layer FL may be provided on at least one of the lower conductive layer LCL, the lower conductive pattern LCP, and the insulating pattern IP. The lower active contact LAC may penetrate the filling insulating layer FL in the third direction D3. The filling insulating layers FL may be extended in the second direction D2. The filling insulating layers FL may be arranged to be spaced apart from each other in the first direction D1. The filling insulating layer FL may include an insulating material. For example, the filling insulating layer FL may be formed of or include at least one of nitride materials.

Lower patterns LP may be provided. In an implementation, a plurality of lower patterns LP may be provided on each filling insulating layer FL. The lower patterns LP, which are provided on each filling insulating layer FL, may be arranged to be spaced apart from each other in the second direction D2. In an implementation, the lower patterns LP may be formed of or include at least one of insulating and semiconductor materials.

A device isolation layer ST may be provided. The lower active contact LAC and the filling insulating layer FL may penetrate the device isolation layer ST in the third direction D3. The device isolation layer ST may include an insulating material. For example, the device isolation layer ST may be formed of or include at least one of oxide materials.

Lower gate contacts LGC may be provided. The lower gate contact LGC may be provided on the lower conductive pattern LCP. A bottom surface of the lower gate contact LGC may be in contact with a top surface of the lower conductive pattern LCP. The lower gate contact LGC may penetrate the filling insulating layer FL and the device isolation layer ST in the third direction D3. The lower gate contact LGC may include a conductive material.

The lower gate contact LGC may include a first contact portion P1 on the lower conductive pattern LCP and second and third contact portions P2 and P3 on the first contact portion P1. The second and third contact portions P2 and P3 may be spaced apart from each other in the first direction D1. The first contact portion P1 may connect the second and third contact portions P2 and P3 to each other. A portion of the device isolation layer ST may be provided between the second and third contact portions P2 and P3. Each of the second and third contact portions P2 and P3 may be overlapped with semiconductor patterns SP, which will be described below, in the third direction D3.

Source/drain patterns SD may be provided. A source/drain pattern includes a doped semiconductor region which functions as a source pattern of a transistor or as a drain pattern of a transistor. The same source/drain pattern may be a source pattern of one transistor and a drain pattern of another transistor. The source/drain pattern SD may be provided on the lower active contact LAC or the lower pattern LP. The lower active contact LAC may be in contact with a lower portion of the source/drain pattern SD. The source/drain patterns SD may include a semiconductor material. The source/drain patterns SD may be epitaxial patterns which are formed by a selective epitaxial growth process.

Channel structures CH may be provided. The channel structures CH may be provided between the source/drain patterns SD, which are adjacent to each other in the second direction D2. Each of the channel structures CH may include a plurality of semiconductor patterns SP, which are overlapped with each other in the third direction D3. The semiconductor patterns SP, which are included in each channel structure CH, may be spaced apart from each other in the third direction D3.

In an implementation, the semiconductor patterns SP may be formed of or include silicon (Si). For example, each of the semiconductor patterns SP may be formed of or include crystalline silicon. In an implementation, the semiconductor patterns SP may be formed of or include silicon-germanium (SiGe).

Gate electrodes GE, which are extended in the first direction D1, may be provided. The gate electrode GE may include portions, which are interposed between the semiconductor patterns SP. The second and third contact portions P2 and P3 of the lower gate contact LGC may be in contact with a lower portion of the gate electrode GE. The gate electrode GE may include a conductive material. The gate electrode GE and the semiconductor pattern SP may constitute a three-dimensional field effect transistor (e.g., MBCFET or GAAFET).

A gate insulating layer GI may be provided to separate the gate electrode GE from the channel structure CH. The gate insulating layer GI may cover top, bottom, and side surfaces of each of the semiconductor patterns SP. The gate insulating layer GI may include an insulating material. As an example, the gate insulating layer GI may be formed of or include at least one of oxide materials.

Gate division layers GD may be provided. The gate division layer GD may be interposed between the gate electrodes GE, which are adjacent to each other in the first direction D1. The gate division layer GD may separate the gate electrodes GE, which are adjacent to each other in the first direction D1. The gate division layer GD may include an insulating material.

A pair of gate spacers GS may be respectively disposed on opposite side surfaces of the gate electrode GE. The gate spacers GS may be extended along the gate electrode GE and in the first direction D1. Top surfaces of the gate spacers GS may be higher than a top surface of the gate electrode GE. The top surfaces of the gate spacers GS may be coplanar with a top surface of an interlayer insulating layer 130, which will be described below.

A gate capping pattern GP may be provided on the gate electrode GE. The gate capping pattern GP may be extended along the gate electrode GE and in the first direction D1. The gate capping pattern GP may include an insulating material. For example, the gate capping pattern GP may be formed of or include at least one of nitride materials.

An interlayer insulating layer 130 may be provided on the gate spacers GS and the source/drain patterns SD. A top surface of the interlayer insulating layer 130 may be coplanar with a top surface of the gate capping pattern GP and a top surface of a gate spacer GS. A first upper insulating layer 140 may be provided on the interlayer insulating layer 130 to cover the gate capping pattern GP. A second upper insulating layer 150 may be provided on the first upper insulating layer 140. A third upper insulating layer 160 may be provided on the second upper insulating layer 150. The interlayer insulating layer 130 and the first to third upper insulating layers 140, 150, and 160 may include an insulating material. In an implementation, the interlayer insulating layer 130 and the first to third upper insulating layers 140, 150, and 160 may be formed of or include at least one of oxide materials.

Upper active contacts UAC may be provided. The upper active contacts UAC may be provided to penetrate the first upper insulating layer 140. The upper active contact UAC may be in contact with an upper portion of the source/drain pattern SD.

In an implementation, the source/drain pattern SD may include a metal-semiconductor compound layer, which is in contact with the lower or upper active contact LAC or UAC. For example, the metal-semiconductor compound layer may be formed of or include at least one of titanium silicide, tantalum silicide, tungsten silicide, nickel silicide, or cobalt silicide.

In an implementation, each of the upper and lower active contacts UAC and LAC may include a conductive pattern and a barrier pattern. The barrier pattern may be in contact with the source/drain pattern SD. The conductive pattern may be spaced apart from the source/drain pattern SD by the barrier pattern. For example, the conductive pattern may include at least one of aluminum, copper, tungsten, molybdenum, or cobalt, and the barrier pattern may include at least one of titanium, tantalum, tungsten, nickel, cobalt, titanium nitride (TiN), tantalum nitride (TaN), tungsten nitride (WN), nickel nitride (NiN), cobalt nitride (CoN), or platinum nitride (PtN).

Upper gate contacts UGC may be provided. The upper gate contact UGC may penetrate the first upper insulating layer 140 and the gate capping pattern GP. The upper gate contact UGC may be in contact with an upper portion of the gate electrode GE. The upper gate contact UGC may be in contact with a top surface of the upper active contact UAC. The upper gate contact UGC may include a conductive material.

Vias VI may be provided. The vias VI may penetrate the second upper insulating layer 150 in the third direction D3. A bottom surface of the via VI may be in contact with a top surface of the upper active contact UAC. The via VI may include a conductive material.

A first bit line BL1a, a second bit line BL2a, a third bit line BL3a, a fourth bit line BL4a, a first upper conductive line UCL1, and a second upper conductive line UCL2 may be provided. The first to fourth bit lines BL1a, BL2a, BL3a, and BL4a and the first and second upper conductive lines UCL1 and UCL2 may penetrate the third upper insulating layer 160 in the third direction D3. Each of the first to fourth bit lines BL1a, BL2a, BL3a, and BL4a and the first and second upper conductive lines UCL1 and UCL2 may have a bottom surface that is in contact with a top surface of the via VI.

The first upper conductive line UCL1 may be disposed between the first and second bit lines BL1a and BL2a. The second upper conductive line UCL2 may be disposed between the third and fourth bit lines BL3a and BL4a. The second and third bit lines BL2a and BL3a may be disposed between the first and second upper conductive lines UCL1 and UCL2.

The first to fourth bit lines BL1a, BL2a, BL3a, and BL4a and the first and second upper conductive lines UCL1 and UCL2 may be extended in the second direction D2. The first to fourth bit lines BL1a, BL2a, BL3a, and BL4a and the first and second upper conductive lines UCL1 and UCL2 may be arranged in the first direction D1 to be spaced apart from each other. The first to fourth bit lines BL1a, BL2a, BL3a, and BL4a and the first and second upper conductive lines UCL1 and UCL2 may include a conductive material.

The source/drain patterns SD, the lower active contacts LAC, the upper active contacts UAC, the gate electrodes GE, the lower gate contacts LGC, and the upper gate contacts UGC may be disposed between each of the first and second upper conductive lines UCL1 and UCL2 and the lower conductive layer LCL.

The semiconductor device may include a plurality of SRAM cells SRC. The SRAM cells SRC may include a 6T SRAM cell SRC, which includes a first transistor TR1, a second transistor TR2, a third transistor TR3, a fourth transistor TR4, a fifth transistor TR5, and a sixth transistor TR6.

The source/drain patterns SD may include a first source/drain pattern SD1, a second source/drain pattern SD2, a third source/drain pattern SD3, a fourth source/drain pattern SD4, a fifth source/drain pattern SD5, a sixth source/drain pattern SD6, a seventh source/drain pattern SD7, an eighth source/drain pattern SD8, a ninth source/drain pattern SD9, and a tenth source/drain pattern SD10.

The lower active contacts LAC may include a first lower active contact LAC1, which is in contact with a lower portion of the first source/drain pattern SD1, and a second lower active contact LAC2, which is in contact with a lower portion of the second source/drain pattern SD2. The first source/drain pattern SD1 may be provided on the first lower active contact LAC1. The second source/drain pattern SD2 may be provided on the second lower active contact LAC2. The first and second source/drain patterns SD1 and SD2 and the first and second lower active contacts LAC1 and LAC2 may be electrically connected to the lower conductive layer LCL. A bottom surface of the first lower active contact LAC1 may be in contact with a top surface of the first lower conductive portion LCL1. A bottom surface of the second lower active contact LAC2 may be in contact with a top surface of the second lower conductive portion LCL2.

The third to tenth source/drain patterns SD3, SD4, SD5, SD6, SD7, SD8, SD9, and SD10 may be disposed between the first and second source/drain patterns SD1 and SD2. A distance between one of the third to tenth source/drain patterns SD3, SD4, SD5, SD6, SD7, SD8, SD9, and SD10 and the first or second source/drain pattern SD1 or SD2 may be smaller than a distance between the first and second source/drain patterns SD1 and SD2. The third source/drain pattern SD3 may be adjacent to the first source/drain pattern SD1 in the first direction D1.

The upper active contacts UAC may include a first upper active contact UAC1 in contact with an upper portion of the third source/drain pattern SD3, a second upper active contact UAC2 in contact with an upper portion of the fourth source/drain pattern SD4, a third upper active contact UAC3 in contact with an upper portion of the fifth source/drain pattern SD5, a fourth upper active contact UAC4 in contact with an upper portion of the sixth source/drain pattern SD6, a fifth upper active contact UAC5 in contact with upper portions of the seventh and eighth source/drain patterns SD7 and SD8, and a sixth upper active contact UAC6 in contact with upper portions of the ninth and tenth source/drain patterns SD9 and SD10.

The third source/drain pattern SD3 and the first upper active contact UAC1 may be electrically connected to the first upper conductive line UCL1 through the via VI. The fourth source/drain pattern SD4 and the second upper active contact UAC2 may be electrically connected to the first upper conductive line UCL1 through the via VI.

The fifth source/drain pattern SD5 and the third upper active contact UAC3 may be electrically connected to the first bit line BL1a through the via VI. The sixth source/drain pattern SD6 and the fourth upper active contact UAC4 may be electrically connected to the second bit line BL2a through the via VI.

The upper gate contacts UGC may include a first upper gate contact UGC1, which is in contact with a top surface of the fifth upper active contact UAC5, and a second upper gate contact UGC2, which is in contact with a top surface of the sixth upper active contact UAC6.

The gate electrodes GE may include a first gate electrode GE1 in contact with the first upper gate contact UGC1 and a second gate electrode GE2 in contact with the second upper gate contact UGC2. The seventh and eighth source/drain patterns SD7 and SD8 and the fifth upper active contact UAC5 may be electrically connected to the first gate electrode GE1 through the first upper gate contact UGC1. The ninth and tenth source/drain patterns SD9 and SD10 and the sixth upper active contact UAC6 may be electrically connected to the second gate electrode GE2 through the second upper gate contact UGC2.

The first gate electrode GE1 may be disposed between the fourth and tenth source/drain patterns SD4 and SD10 and between the second and ninth source/drain patterns SD2 and SD9. The first gate electrode GE1 may be adjacent to the fourth and tenth source/drain patterns SD4 and SD10 and the second and ninth source/drain patterns SD2 and SD9. The second gate electrode GE2 may be disposed between the third and eighth source/drain patterns SD3 and SD8 and between the first and seventh source/drain patterns SD1 and SD7. The second gate electrode GE2 may be adjacent to the third and eighth source/drain patterns SD3 and SD8 and the first and seventh source/drain patterns SD1 and SD7.

The gate electrodes GE may further include a third gate electrode GE3 between the fifth and seventh source/drain patterns SD5 and SD7 and a fourth gate electrode GE4 between the sixth and ninth source/drain patterns SD6 and SD9. The third gate electrode GE3 may be adjacent to the fifth and seventh source/drain patterns SD5 and SD7. The fourth gate electrode GE4 may be adjacent to the sixth and ninth source/drain patterns SD6 and SD9.

The lower gate contacts LGC may include a first lower gate contact LGC1 in contact with a lower portion of the third gate electrode GE3 and a second lower gate contact LGC2 in contact with a lower portion of the fourth gate electrode GE4. The third gate electrode GE3 may be electrically connected to the first word line WL1 through the first lower gate contact LGC1, the lower conductive pattern LCP, and the word line connection pattern WLC. The fourth gate electrode GE4 may be electrically connected to the second word line WL2 through the second lower gate contact LGC2, the lower conductive pattern LCP, and the word line connection pattern WLC.

The first and seventh source/drain patterns SD1 and SD7 and the second gate electrode GE2 may be used as source/drain and gate electrodes of the first transistor TR1. The second and ninth source/drain patterns SD2 and SD9 and the first gate electrode GE1 may be used as source/drain and gate electrodes of the second transistor TR2. The third and eighth source/drain patterns SD3 and SD8 and the second gate electrode GE2 may be used as source/drain and gate electrodes of the third transistor TR3. The fourth and tenth source/drain patterns SD4 and SD10 and the first gate electrode GE1 may be used as source/drain and gate electrodes of the fourth transistor TR4. The fifth and seventh source/drain patterns SD5 and SD7 and the third gate electrode GE3 may be used as source/drain and gate electrodes of the fifth transistor TR5. The sixth and ninth source/drain patterns SD6 and SD9 and the fourth gate electrode GE4 may be used as source/drain and gate electrodes of the sixth transistor TR6.

In an implementation, the first and second transistors TR1 and TR2 may be pull-down transistors, the third and fourth transistors TR3 and TR4 may be pull-up transistors, and the fifth and sixth transistors TR5 and TR6 may be pass-gate transistors. In this case, the first, second, fifth, sixth, seventh and ninth source/drain patterns SD1, SD2, SD5, SD6, SD7, and SD9 may have a first conductivity type (e.g., n-type), and the third, fourth, eighth and tenth source/drain patterns SD3, SD4, SD8, and SD10 may have a second conductivity type (e.g., p-type) different from the first conductivity type. In addition, the first upper conductive line UCL1 may be used as the power line VDD, and the lower conductive layer LCL may be used as the ground line VSS.

In an implementation, the first and second transistors TR1 and TR2 may be pull-up transistors, the third and fourth transistors TR3 and TR4 may be pull-down transistors, and the fifth and sixth transistors TR5 and TR6 may be pass-gate transistors. In this case, the first, second, fifth, sixth, seventh and ninth source/drain patterns SD1, SD2, SD5, SD6, SD7, and SD9 may have a first conductivity type (e.g., p-type) and the third, fourth, eighth and tenth source/drain patterns SD3, SD4, SD8, and SD10 may have a second conductivity type (e.g., n-type) different from the first conductivity type. The first upper conductive line UCL1 may be used as the ground line VSS, and the lower conductive layer LCL may be used as the power line VDD.

A distance between the first and second upper active contacts UAC1 and UAC2 may be smaller than a distance between the first and second lower active contacts LAC1 and LAC2. The first lower conductive portion LCL1 may be overlapped with the first lower active contact LAC1, the first source/drain pattern SD1, and the first bit line BL1a in the third direction D3. The second lower conductive portion LCL2 may be overlapped with the second lower active contact LAC2, the second source/drain pattern SD2, and the second bit line BL2a in the third direction D3. The fourth lower conductive portion LCL4 may be overlapped with the first upper conductive line UCL1, the first, second, fifth and sixth upper active contacts UAC1, UAC2, UAC5, and UAC6, the third, fourth, eighth and tenth source/drain patterns SD3, SD4, SD8, and SD10, and the first and second upper gate contacts UGC1 and UGC2 in the third direction D3. The first upper conductive line UCL1 may be disposed between the first lower conductive portion LCL1 and the second lower conductive portion LCL2.

The first lower gate contact LGC1, the lower conductive pattern LCP, and the word line connection pattern WLC, which are connected to each other, may be overlapped with the first bit line BL1a in the third direction D3. The second lower gate contact LGC2, the lower conductive pattern LCP, and the word line connection pattern WLC, which are connected to each other, may be overlapped with the second bit line BL2a in the third direction D3.

In the semiconductor device, the word lines WL1 and WL2 and the lower conductive layer LCL may be disposed below the source/drain patterns SD, and the bit lines BL1a, BL2a, BL3a, and BL4a and the upper conductive lines UCL1 and UCL2 may be disposed on the source/drain patterns SD. In this case, it may be possible to improve a degree of freedom in designing interconnection lines and improve a parasitic capacitance between the interconnection lines.

In an implementation, since the semiconductor device includes the lower gate contact LGC, the lower conductive pattern LCP, and the word line connection pattern WLC, the gate electrode GE may be electrically connected to the word line WL1 or WL2, which are placed below the source/drain patterns SD.

In an implementation, the semiconductor device may include the lower conductive layer LCL, which includes the lower conductive portions LCL1, LCL2, LCL3, and LCL5 extending in the first direction D1 and the lower conductive portions LCL4 and LCL6 extending in the second direction D2, and the lower active contacts LAC. In this case, the first and second source/drain patterns SD1 and SD2, which are spaced apart from each other by a relatively large distance, may be electrically connected to the lower conductive layer LCL.

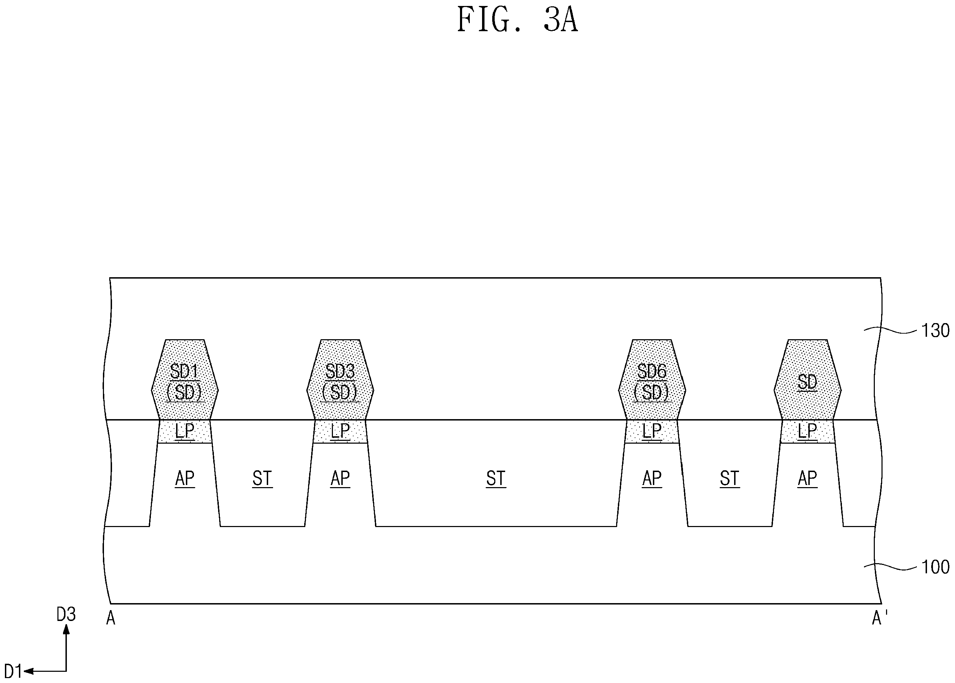

FIGS. 3A, 3B, 3C, 4A, 4B, 4C, 5A, 5B, 5C, 6A, 6B, 7A, 7B, and 7C are sectional views illustrating a method of fabricating the semiconductor device of FIG. 2A to 2G.

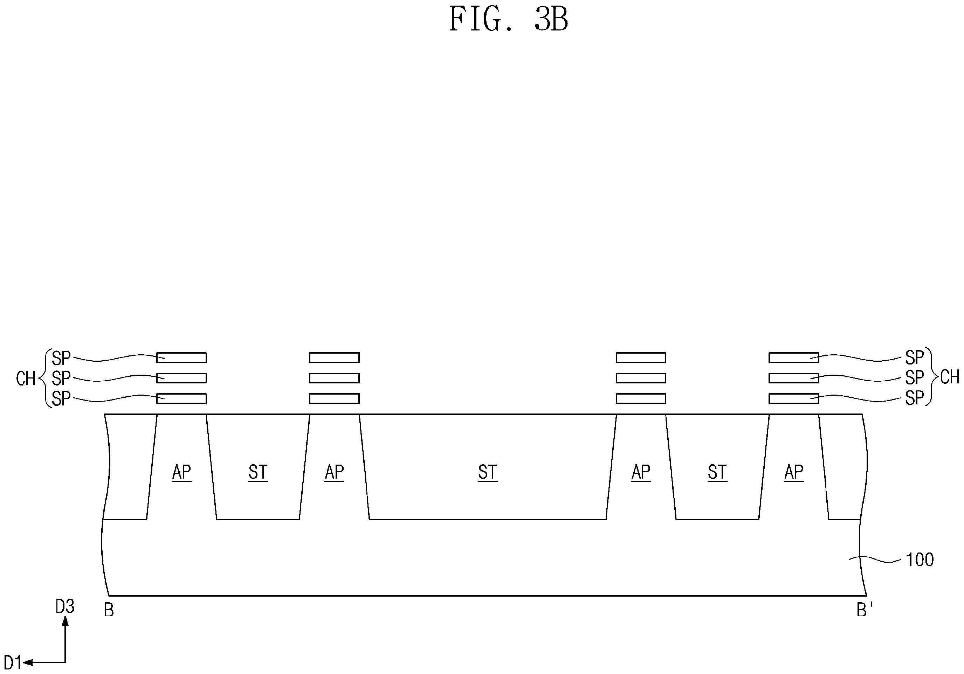

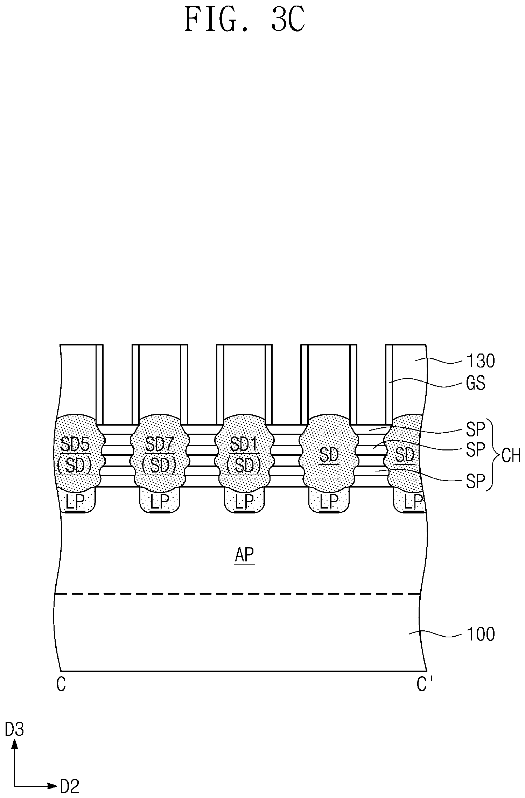

Referring to FIGS. 3A, 3B, and 3C, a substrate 100 may be patterned to form active patterns AP. The substrate 100 may be a semiconductor substrate, an insulating substrate, a silicon-on-insulator (SOI) substrate, or a germanium-on-insulator (GOI) substrate. The device isolation layer ST may be formed on the substrate 100.

The gate spacers GS and the channel structures CH may be formed. The lower patterns LP, the source/drain patterns SD, and the interlayer insulating layers 130 may be formed.

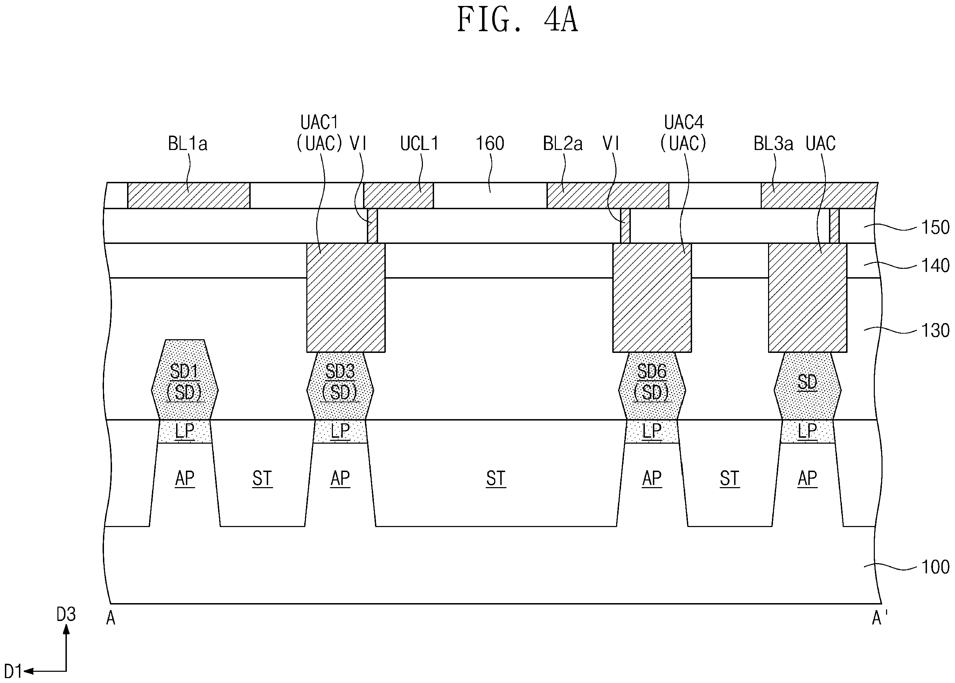

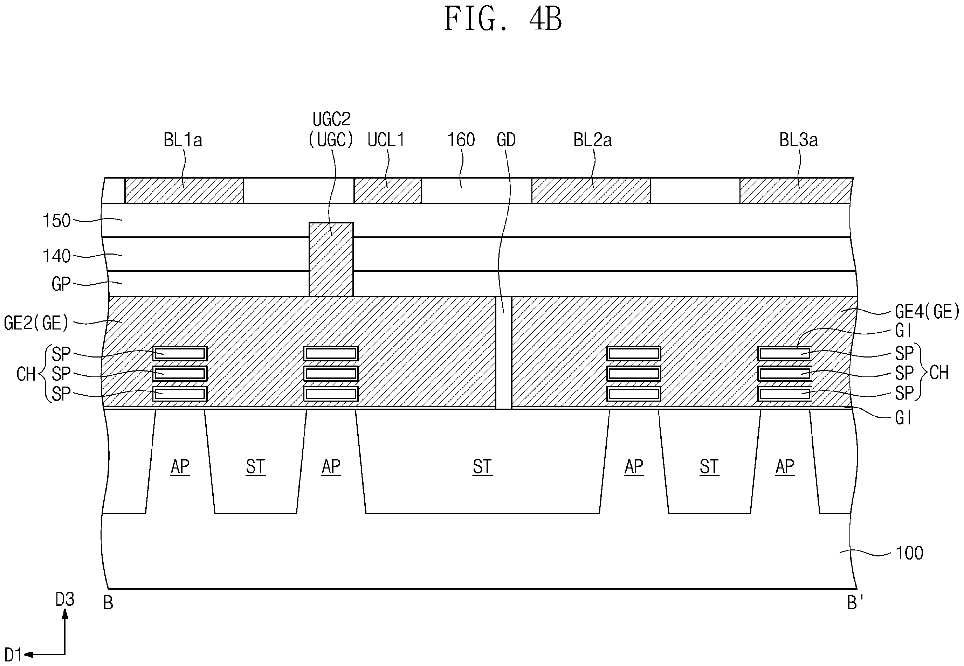

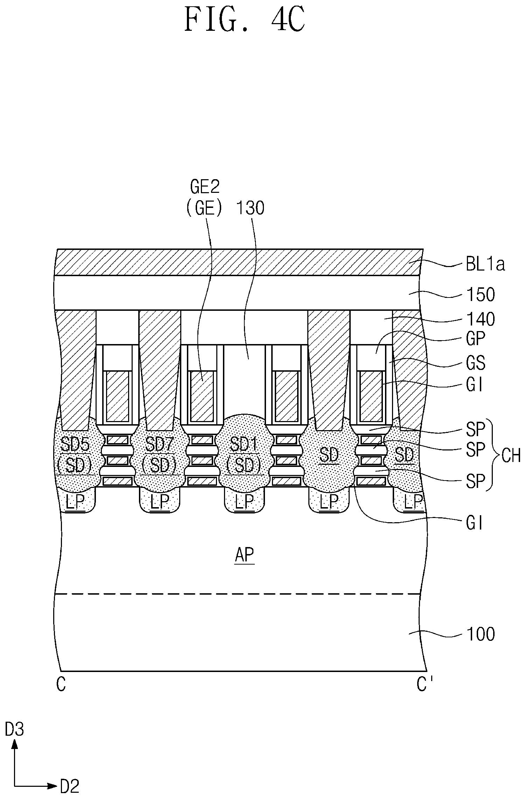

Referring to FIGS. 4A, 4B, and 4C, the gate insulating layers GI, the gate electrodes GE, the gate division layers GD, and the gate capping patterns GP may be formed.

The first upper insulating layer 140 may be formed. The upper active contacts UAC may be formed. The upper gate contacts UGC may be formed. The second upper insulating layer 150 may be formed. The vias VI may be formed. The third upper insulating layer 160 may be formed. The first to fourth bit lines BL1a, BL2a, BL3a, and BL4a and the first and second upper conductive lines UCL1 and UCL2 may be formed.

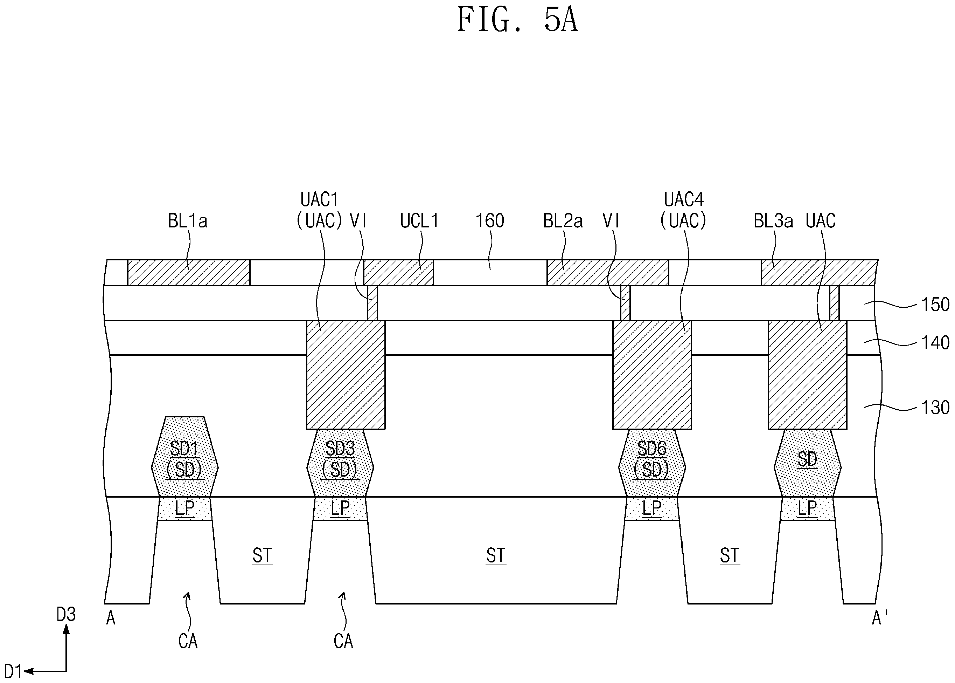

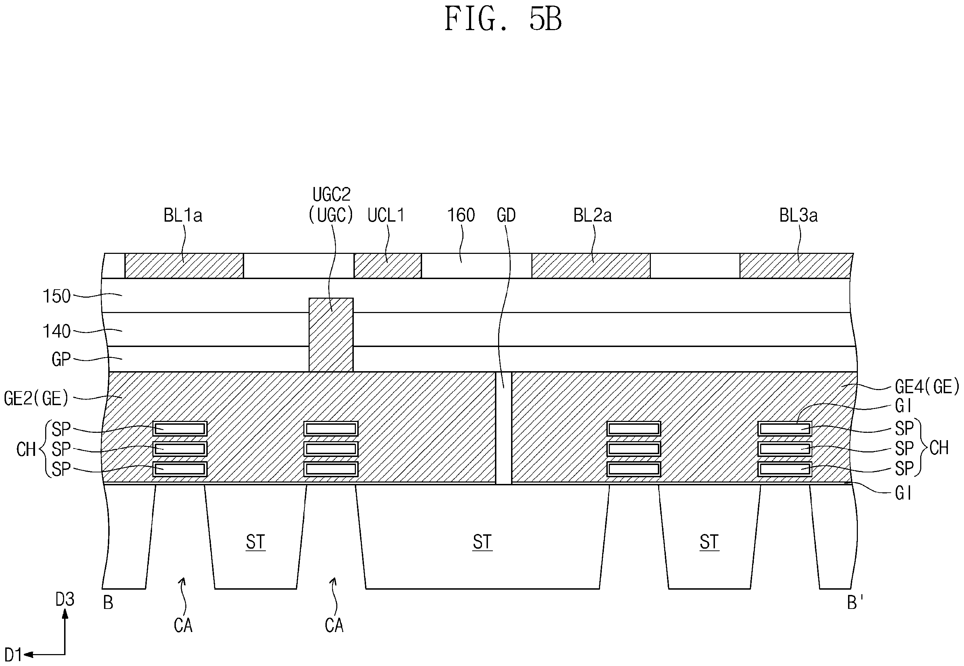

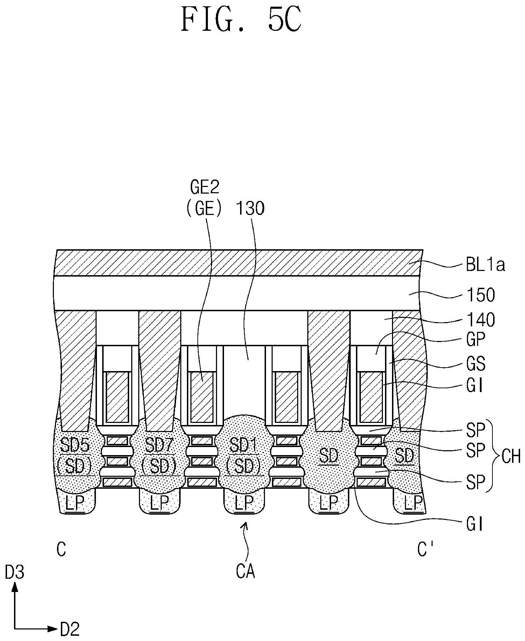

Referring to FIGS. 5A, 5B, and 5C, the substrate 100 may be removed. As an example, the substrate 100 may be removed by at least one of thinning and grinding processes. An empty space, which is formed by removing the active pattern AP, may be defined as a first cavity CA. The lower pattern LP and the gate insulating layer GI may be exposed through the first cavity CA.

In an implementation, a handling substrate may be formed on the third upper insulating layer 160, before the removal of the substrate 100.

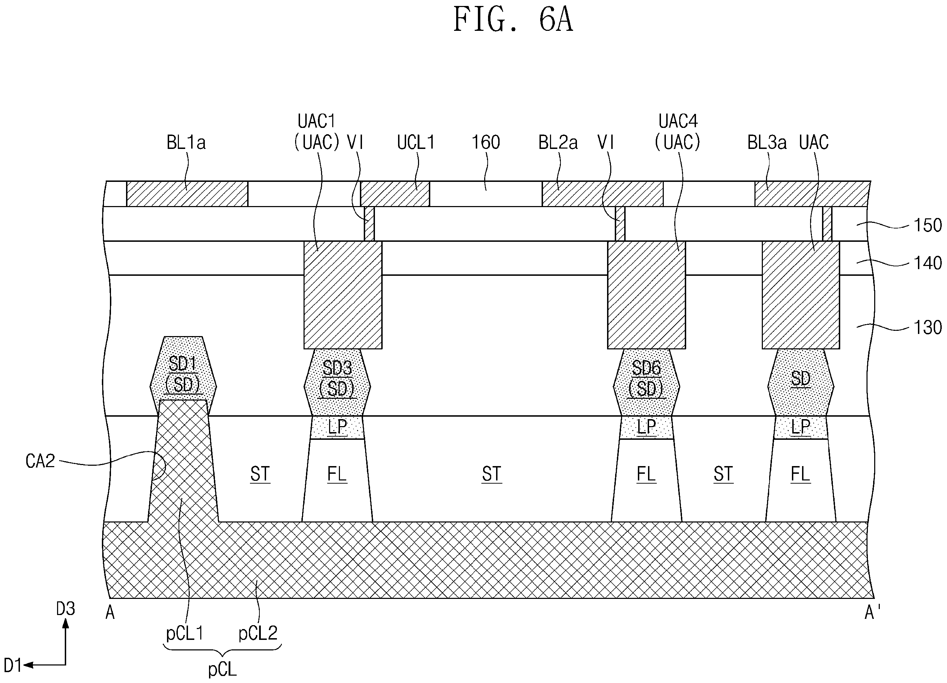

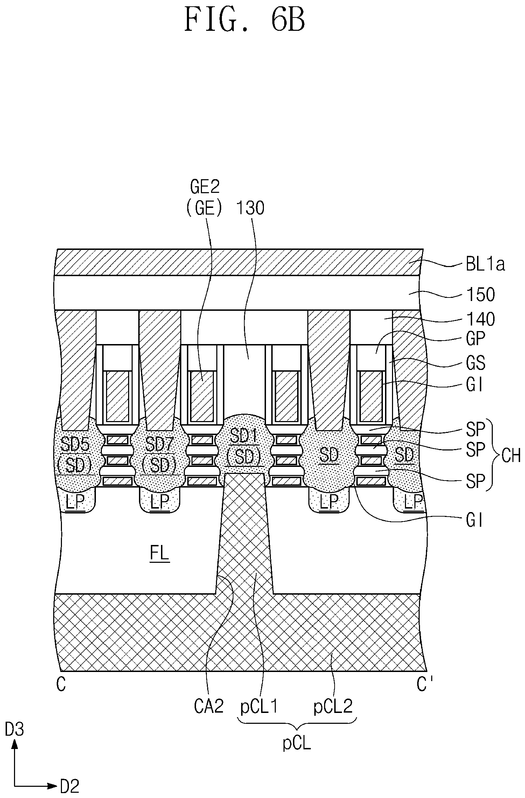

Referring to FIGS. 6A and 6B, the filling insulating layers FL may be formed. The formation of the filling insulating layers FL may include forming a preliminary filling insulating layer to fill the first cavities CA and removing a lower portion of the preliminary filling insulating layer to form the filling insulating layers FL. The preliminary filling insulating layer may include lower and upper portions. Each of the upper portions of the preliminary filling insulating layer may be provided in the first cavity CA. As a result of the removal of the lower portion of the preliminary filling insulating layer, the upper portions of the preliminary filling insulating layer may be separated from each other. The separated upper portions of the preliminary filling insulating layer may be defined as the filling insulating layers FL.

A preliminary conductive layer pCL may be formed. The formation of the preliminary conductive layer pCL may include etching some of the filling insulating layers FL and some of the lower patterns LP to form second cavities CA2 and forming the preliminary conductive layer pCL to fill the second cavities CA2.

The etching of some of the filling insulating layers FL and some of the lower patterns LP may include forming a mask layer and etching some of the filling insulating layers FL and some of the lower patterns LP using the mask layer as an etch mask. The preliminary conductive layer pCL may include upper portions pCL1, which are provided in the second cavities CA2, and a lower portion pCL2, which connects the upper portions pCL1 to each other.

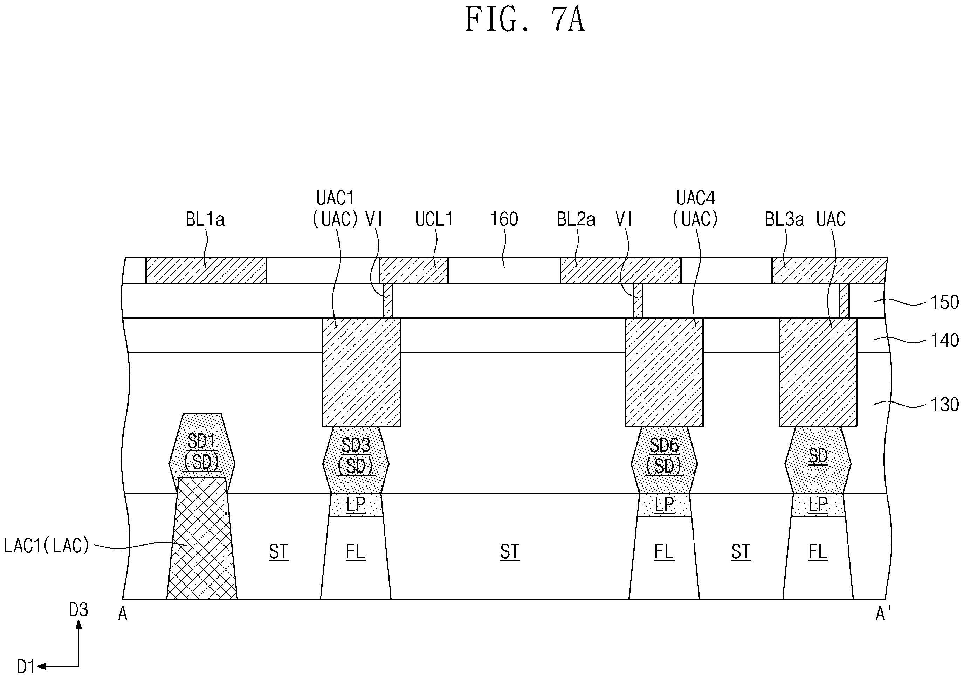

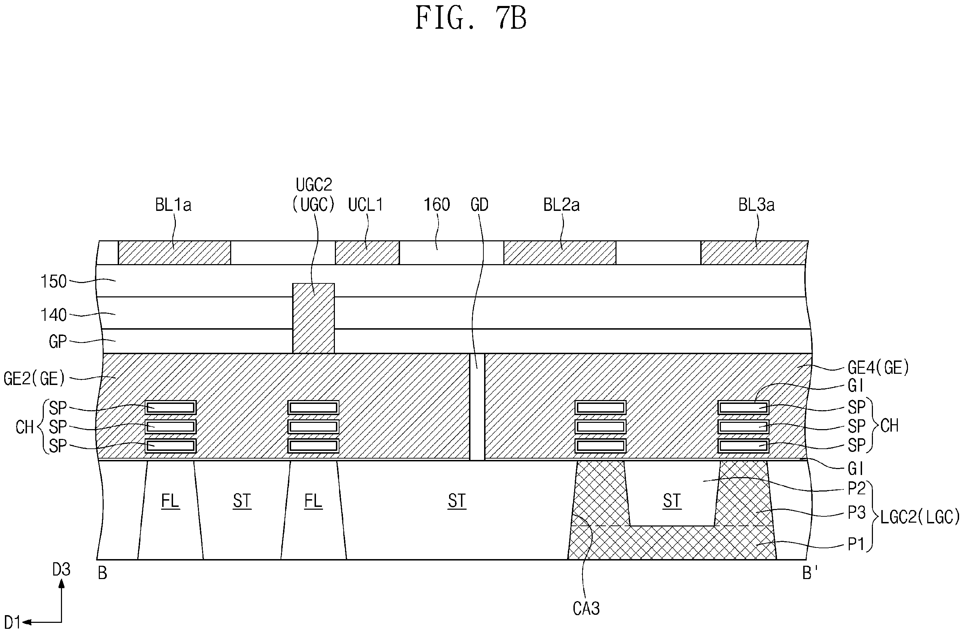

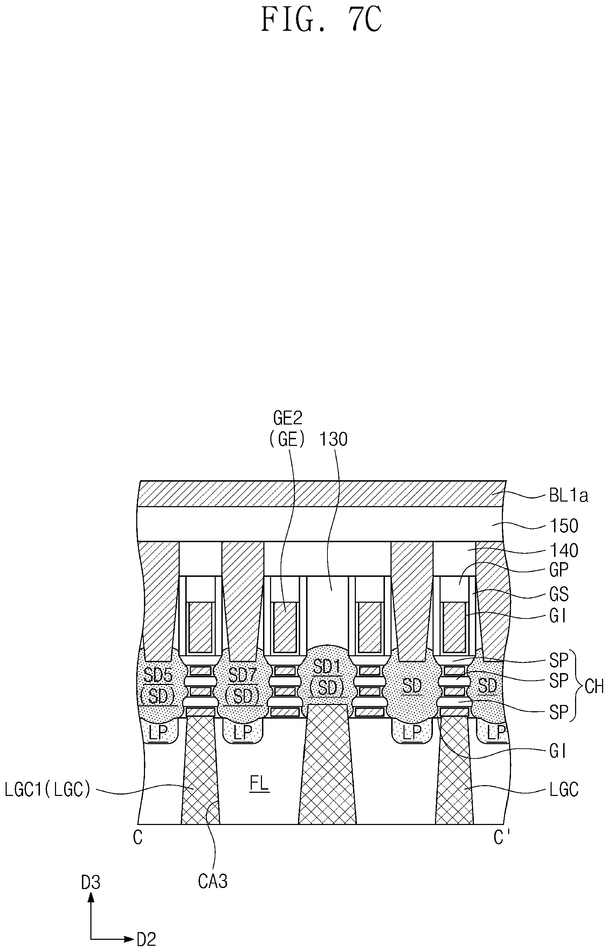

Referring to FIGS. 7A and 7B, the lower portion pCL2 of the preliminary conductive layer pCL may be removed. Since the lower portion pCL2 of the preliminary conductive layer pCL is removed, the upper portions pCL1 of the preliminary conductive layer pCL may be separated from each other. The separated upper portions pCL1 of the preliminary conductive layer pCL may be defined as the lower active contacts LAC.

As a result of the removal of the lower portion pCL2 of the preliminary conductive layer pCL, the filling insulating layers FL and the device isolation layer ST may be exposed. A third cavity CA3 may be formed by etching portions of the filling insulating layers FL and the device isolation layer ST. The third cavity CA3 may be formed to expose the gate electrode GE. The lower gate contact LGC may be formed in the third cavity CA3.

Referring to FIGS. 2A to 2G, the insulating patterns IP, the lower conductive layer LCL, and the lower conductive patterns LCP may be formed. The second lower insulating layer 120 and the word line connection patterns WLC may be formed. The first lower insulating layer 110 and the first and second word lines WL1 and WL2 may be formed.

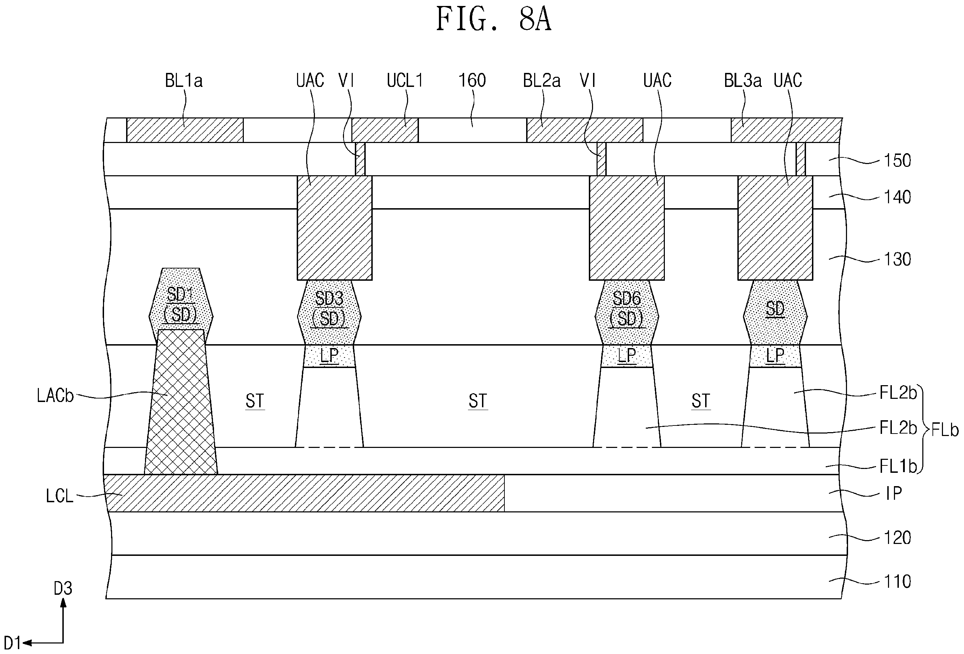

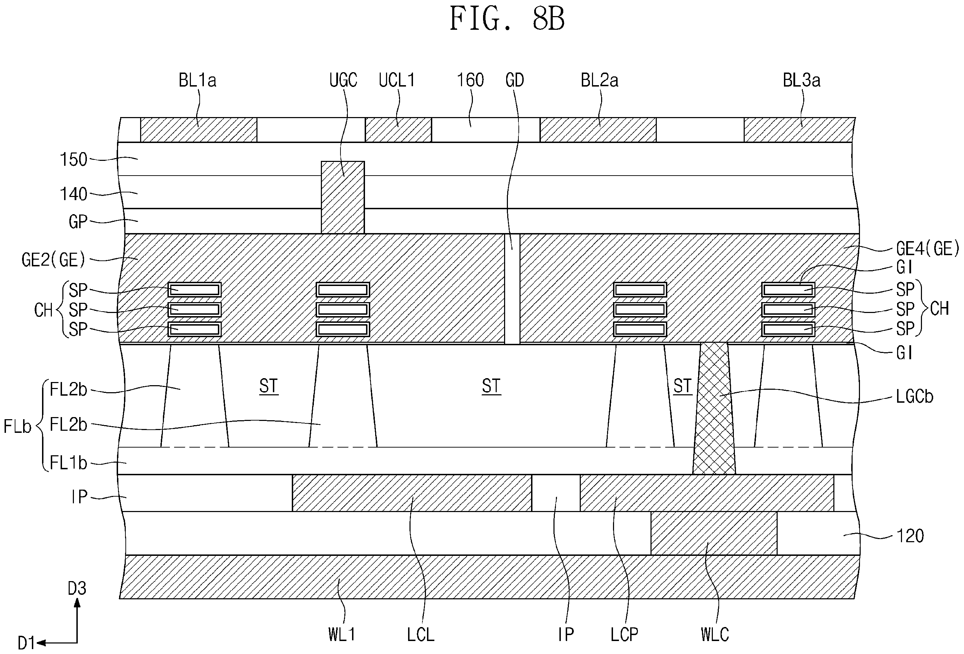

FIGS. 8A and 8B are sectional views illustrating an example semiconductor device. The semiconductor device of FIG. 8A and 8B may have similar features to the semiconductor device of FIGS. 2A to 2G, except for the features to be described below.

Referring to FIGS. 8A and 8B, a filling insulating layer FLb may include upper portions FL2b and a lower portion FL1b. The lower portion FL1b of the filling insulating layer FLb may connect the upper portions FL2b to each other.

The insulating pattern IP, the lower conductive layer LCL, and the lower conductive pattern LCP may be spaced apart from the device isolation layer ST by the lower portion FL1b of the filling insulating layer FLb.

A lower gate contact LGCb may be disposed between the upper portions FL2b of the filling insulating layer FLb. The lower gate contact LGCb may penetrate a portion of the device isolation layer ST, which is disposed between the upper portions FL2b of the filling insulating layer FLb.

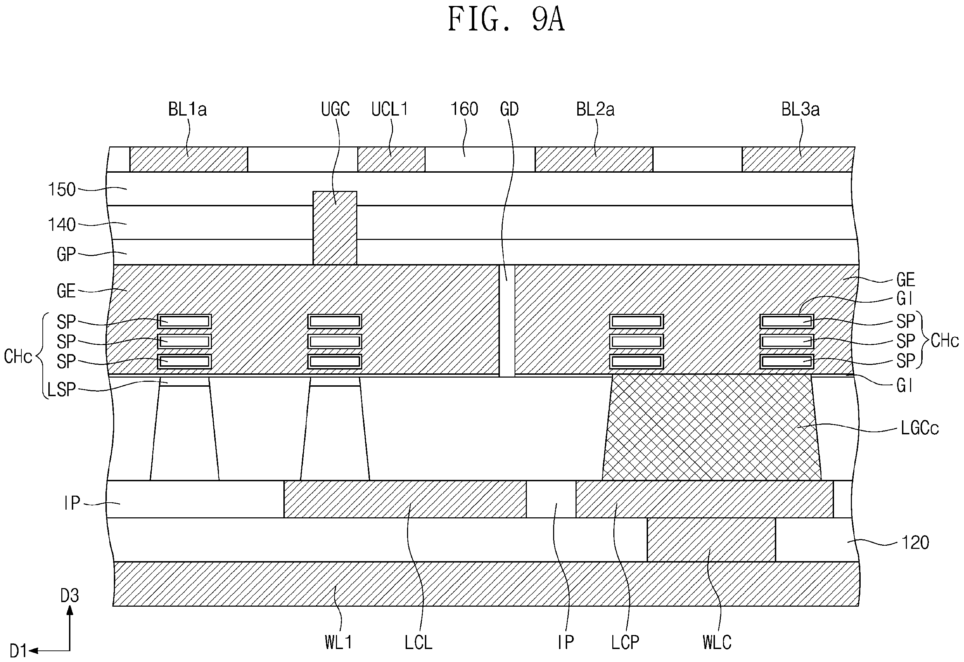

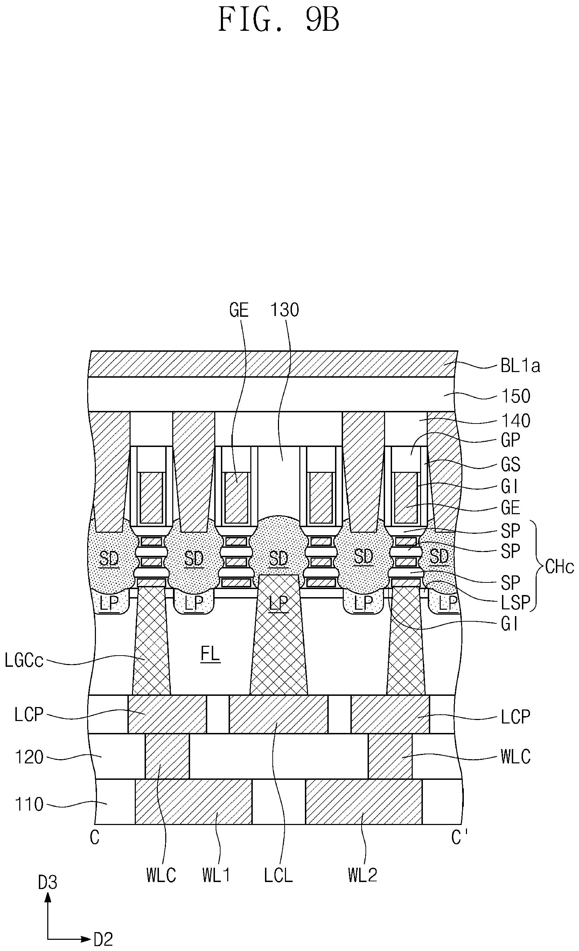

FIGS. 9A and 9B are sectional views illustrating an example semiconductor device. The semiconductor device of FIGS. 9A and 9B may have similar features to the semiconductor device of FIGS. 2A to 2G, except for the features to be described below.

Referring to FIGS. 9A and 9B, a channel structure CHc may include the semiconductor patterns SP and a lower semiconductor pattern LSP. A bottom surface of the lower semiconductor pattern LSP may be in contact with the filling insulating layer FL. A top surface of the lower semiconductor pattern LSP may be in contact with the gate insulating layer GI. The lower semiconductor pattern LSP may include a semiconductor material.

A lower gate contact LGCc may be overlapped with two channel structures CHc in the third direction D3. A width of the lower gate contact LGCc in the first direction D1 may be larger than a distance between two channel structures CHc, which are adjacent to each other in the first direction D1, in the first direction D1. The lower gate contact LGCc may be provided to penetrate the lower semiconductor pattern LSP. In an implementation, an insulating layer may be provided to separate the lower gate contact LGCc from the lower semiconductor pattern LSP.

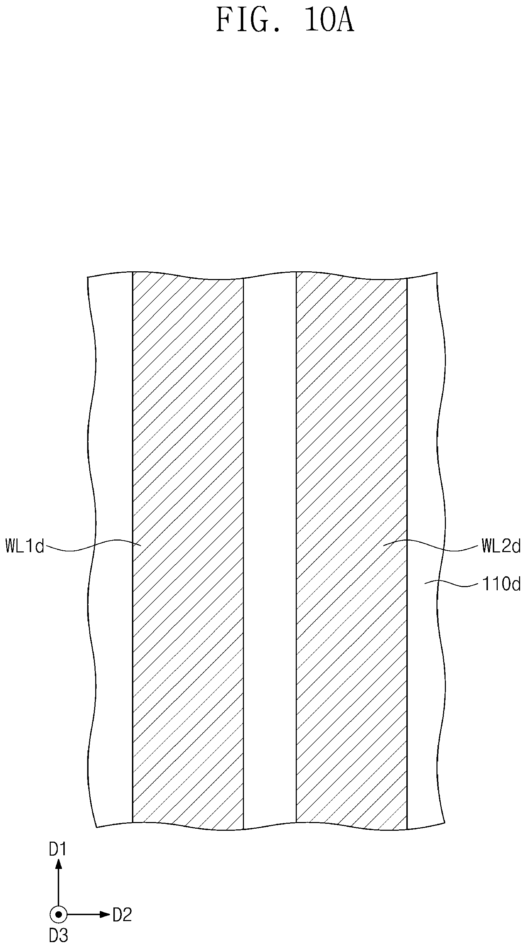

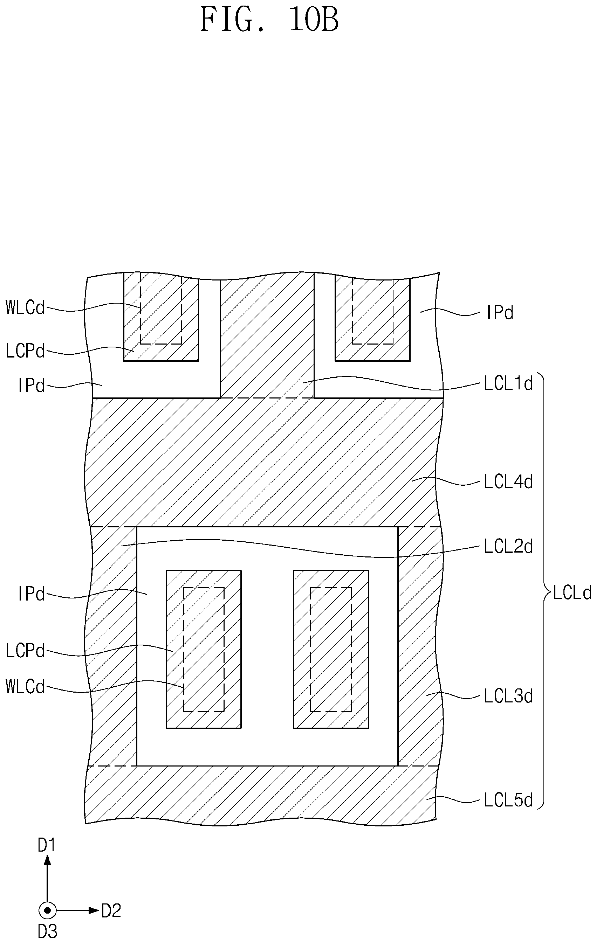

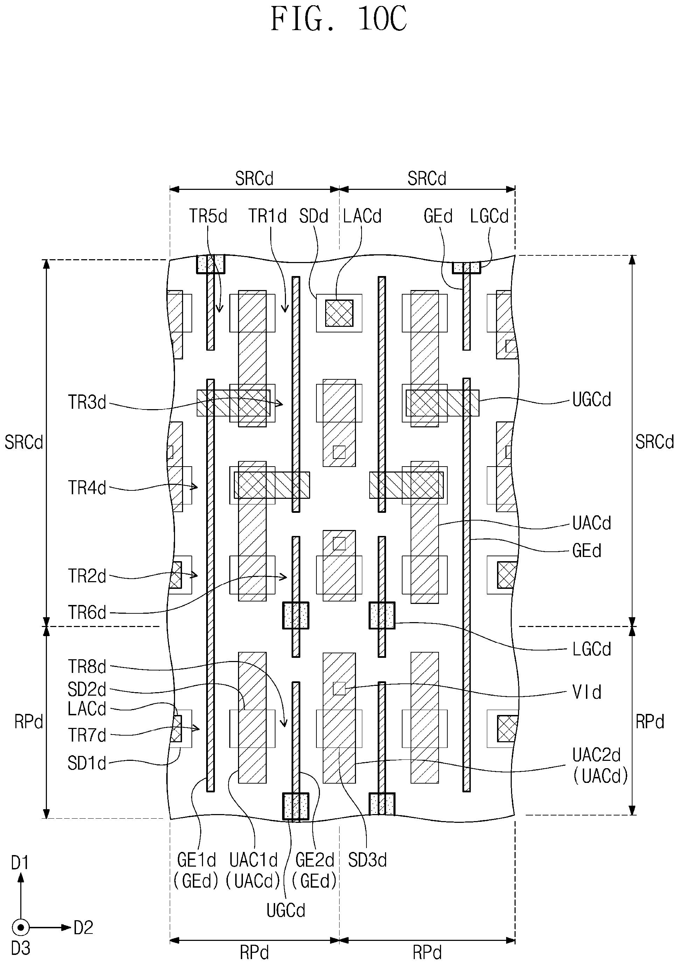

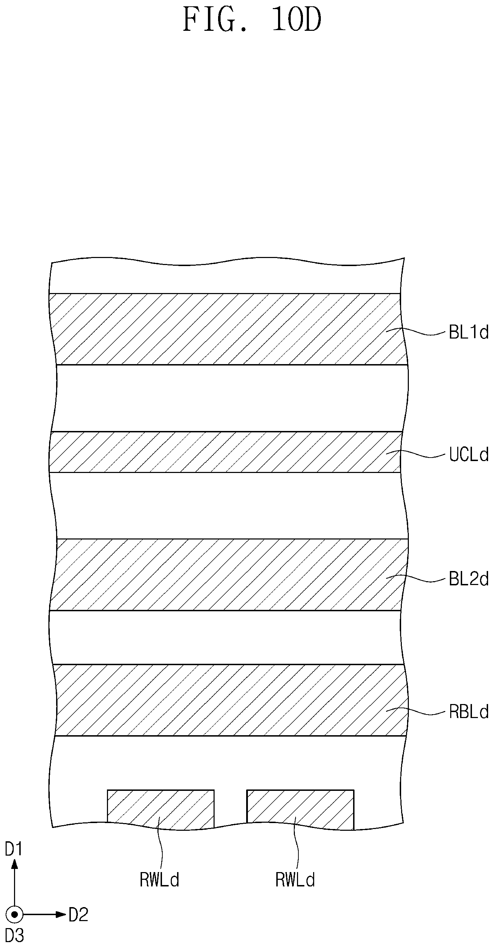

FIG. 10A is a plan view illustrating a word line of an example semiconductor device. FIG. 10B is a plan view illustrating a lower conductive layer, a lower conductive pattern, and a word line connection pattern of an example semiconductor device. FIG. 10C is a plan view illustrating a source/drain pattern, a lower active contact, upper active contact, a lower gate contact, an upper gate contact, and a gate electrode of an example semiconductor device. FIG. 10D is a plan view illustrating an upper conductive line, a bit line, a read word line, and a read bit line of an example semiconductor device.

Referring to FIGS. 10A, 10B, 10C, and 10D, the semiconductor device may include a first lower insulating layer 110d and a first word line WL1d and a second word line WL2d, which are provided in the first lower insulating layer 1 10d. A word line connection pattern WLCd may be provided on the first word line WL1d and the second word line WL2d. A lower conductive pattern LCPd may be provided on the word line connection pattern WLCd.

An insulating pattern IPd may be provided to surround the lower conductive pattern LCPd. A lower conductive layer LCLd may be provided to surround the insulating pattern IPd. The lower conductive layer LCLd may include a first lower conductive portion LCL1d, which is provided between the insulating patterns IPd spaced apart from each other in the second direction D2, a second lower conductive portion LCL2d and a third lower conductive portion LCL3d, which are spaced apart from each other in the second direction D2 with the insulating pattern IPd interposed therebetween, and a fourth lower conductive portion LCL4d and a fifth lower conductive portion LCL5d, which are spaced apart from each other in the first direction D1 with the insulating pattern IPd interposed therebetween. The fourth lower conductive portion LCL4d may connect the first to third lower conductive portions LCL1d, LCL2d, and LCL3d to each other. The fifth lower conductive portion LCL5d may connect the second and third lower conductive portions LCL2d and LCL3d to each other.

The semiconductor device may include SRAM cells SRCd and read ports RPd. The read port RPd may be connected to the SRAM cell SRCd. For example, the read port RPd including a seventh transistor TR7d and an eighth transistor TR8d may be connected to a SRAM cell including a first transistor TR1d, a second transistor TR2d, a third transistor TR3d, a fourth transistor TR4d, a fifth transistor TR5d, and a sixth transistor TR6d. The seventh transistor TR7d may be a pull-down transistor of the read port RPd. The eighth transistor TR8d may be a pass-gate transistor of the read port RPd.

Source/drain patterns SDd may include a first source/drain pattern SD1d, a second source/drain pattern SD2d, and a third source/drain pattern SD3d. The first and second source/drain patterns SD1D and SD2d may be source/drain electrodes of the seventh transistor TR7d. The second and third source/drain patterns SD2d and SD3d may be source/drain electrodes of the eighth transistor TR8d.

Gate electrodes GEd may include a first gate electrode GE1d and a second gate electrode GE2d. The first gate electrode GE1d may be a gate electrode of the seventh transistor TR7d, a gate electrode of the second transistor TR2d, and a gate electrode of the fourth transistor TR4d. The second gate electrode GE2d may be a gate electrode of the eighth transistor TR8d.

Upper active contacts UACd may include a first upper active contact UAC1D and a second upper active contact UAC2d. The first upper active contact UACID may be provided on the second source/drain pattern SD2d. The second upper active contact UAC2d may be provided on the third source/drain pattern SD3d.

The first source/drain pattern SD1d may be electrically connected to the lower conductive layer LCLd through a lower active contact LACd. The second gate electrode GE2d may be electrically connected to a read word line RWLd through an upper gate contact UGCd. The third source/drain pattern SD3d may be electrically connected to a read bit line RBLd through the second upper active contact UAC2d and a via Vid.

The read word lines RWLd and the read bit line RBLd may be disposed at the same level as a first bit line BL1d, a second bit line BL2d, and an upper conductive line UCLd.

Each of the fifth and sixth transistors TR5d and TR6d may be electrically connected to the word line WL1d or WL2d through a lower gate contact LGCd.

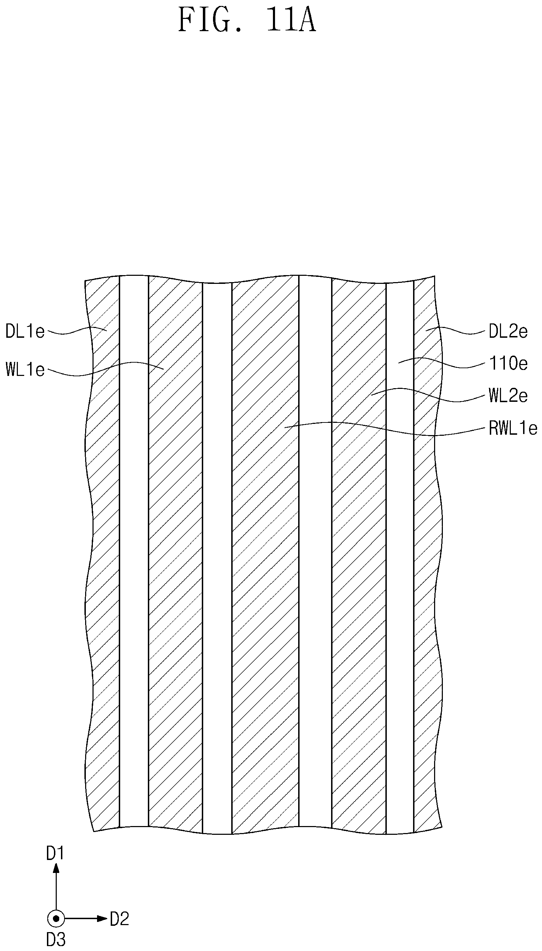

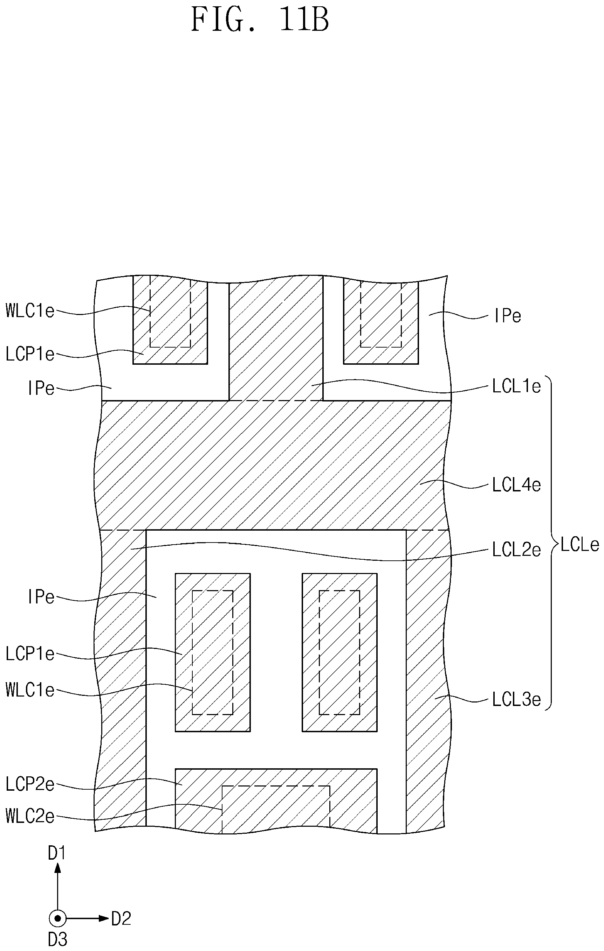

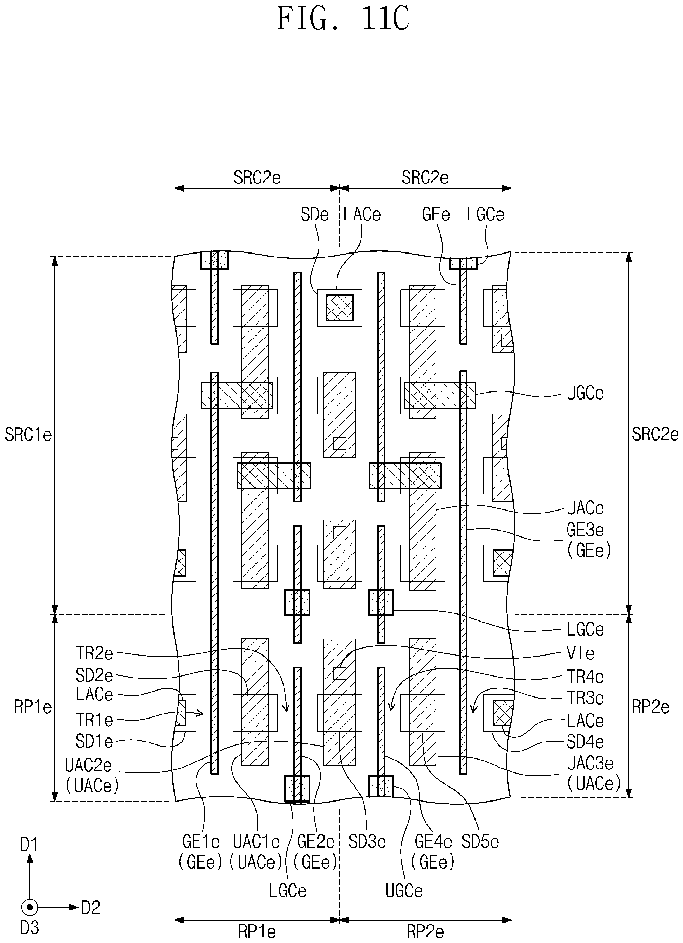

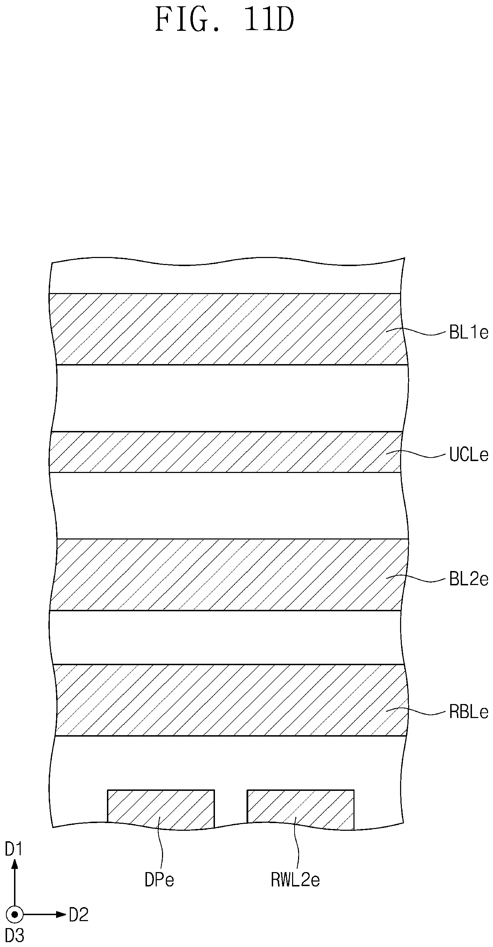

FIG. 11A is a plan view illustrating a word line, a dummy line, and a read word line of an example semiconductor device. FIG. 11B is a plan view illustrating a lower conductive layer, a lower conductive pattern, and a word line connection pattern of an example semiconductor device. FIG. 11C is a plan view illustrating a source/drain pattern, a lower active contact, an upper active contact, a lower gate contact, an upper gate contact, and a gate electrode of an example semiconductor device. FIG. 11D is a plan view illustrating an upper conductive line, a bit line, a read word line, a read bit line, and a dummy pattern of an example semiconductor device.

Referring to FIGS. 11A, 11B, 11C, and 11D, the semiconductor device may include a first word line WL1e, a second word line WL2e, a first read word line RWL1e, a first dummy line DL1e, and a second dummy line DL2e in a first lower insulating layer 110e. The first read word line RWL1e may be disposed between the first and second word lines WL1e and WL2e. The first and second word lines WL1e and WL2e and the first read word line RWL1e may be disposed between the first and second dummy lines DL1e and DL2e. The first and second dummy lines DL1e and DL2e, the first and second word lines WL1e and WL2e, and the first read word line RWL1e may be extended in the first direction D1. The first and second dummy lines DL1e and DL2e, the first and second word lines WL1e and WL2e, and the first read word line RWL1e may be arranged in the second direction D2. The first and second dummy lines DL1e and DL2e, the first and second word lines WL1e and WL2e, and the first read word line RWL1e may be disposed at the same level. The first and second dummy lines DL1e and DL2e, the first and second word lines WL1e and WL2e, and the first read word line RWL1e may be disposed at a level lower than a lower conductive layer LCLe.

The dummy lines DL1e and DL2e may be formed to improve the uniformity in the fabrication process of the semiconductor device. In an implementation, the semiconductor device may not include the dummy lines DL1e and DL2e.

A first word line connection pattern WLC1e may be provided on each of the first and second word lines WL1e and WL2e. A first lower conductive pattern LCP1e may be provided on the first word line connection pattern WLC1e. A second word line connection pattern WLC2e may be provided on the first read word line RWL1e. A second lower conductive pattern LCP2e may be provided on the second word line connection pattern WLC2e. An insulating pattern IPe may be provided to surround the first and second lower conductive patterns LCP1e and LCP2e.

The lower conductive layer LCLe may include a first lower conductive portion LCL1e, which is provided between the first lower conductive patterns LCP1e spaced apart from each other in the second direction D2, a second lower conductive portion LCL2e and a third lower conductive portion LCL3e, which are spaced apart from each other in the second direction D2 with the first and second lower conductive patterns LCP1e and LCP2e interposed therebetween, and a fourth lower conductive portion LCL4e, which is used to connect the first to third lower conductive portions LCL1e, LCL2e, and LCL3e to each other.

The semiconductor device may include a first SRAM cell SRC1e, a second SRAM cell SRC2e, a first read port RP1e, and a second read port RP2e. The first read port RP1e may be connected to the first SRAM cell SRC1e, and the second read port RP2e may be connected to the second SRAM cell SRC2e.

The first read port RP1e may include a first transistor TR1e and a second transistor TR2e. The second read port RP2e may include a third transistor TR3e and a fourth transistor TR4e. The first transistor TR1e may be the pull-down transistor of the first read port RP1e. The second transistor TR2e may be the pass-gate transistor of the first read port RP1e. The third transistor TR3e may be the pull-down transistor of the second read port RP2e. The fourth transistor TR4e may be the pass-gate transistor of the second read port RP2e.

Source/drain patterns SDe may include a first source/drain pattern SD1e, a second source/drain pattern SD2e, a third source/drain pattern SD3e, a fourth source/drain pattern SD4e, and a fifth source/drain pattern SD5e. The first and second source/drain patterns SD1e and SD2e may be source/drain electrodes of the first transistor TR1e. The second and third source/drain patterns SD2e and SD3e may be source/drain electrodes of the second transistor TR2e. The fourth and fifth source/drain patterns SD4e and SD5e may be source/drain electrodes of the third transistor TR3e. The third and fifth source/drain patterns SD3e and SD5e may be source/drain electrodes of the fourth transistor TR4e.

Gate electrodes GEe may include a first gate electrode GE1e, a second gate electrode GE2e, a third gate electrode GE3e, and a fourth gate electrode GE4e. The first gate electrode GE1e may be a gate electrode of the first transistor TR1e. The first gate electrode GE1e may be a gate electrode of a transistor of the first SRAM cell SRC1e. The second gate electrode GE2e may be a gate electrode of the second transistor TR2e. The third gate electrode GE3e may be a gate electrode of the third transistor TR3e. The third gate electrode GE3e may be a gate electrode of a transistor of the second SRAM cell SRC2e. The second gate electrode GE2e may be a gate electrode of the fourth transistor TR4e.

Upper active contacts UACe may include a first upper active contact UAC1e on the second source/drain pattern SD2e, a second upper active contact UAC2e on the third source/drain pattern SD3e, and a third upper active contact UAC3e on the fifth source/drain pattern SD5e.

The first source/drain pattern SD1e may be electrically connected to the lower conductive layer LCLe through a lower active contact LACe. The second gate electrode GE2e may be electrically connected to the second lower conductive pattern LCP2e, the second word line connection pattern WLC2e, and the first read word line RWL1e through a lower gate contact LGCe. The third source/drain pattern SD3e may be electrically connected to a read bit line RBLe through a via VIe. The fourth gate electrode GE4e may be electrically connected to a second read word line RWL2e through an upper gate contact UGCe. The fourth source/drain pattern SD4e may be electrically connected to the lower conductive layer LCLe through the lower active contact LACe.

The read bit line RBLe, the second read word line RWL2e, and a dummy pattern DPe may be disposed at the same level as a first bit line BL1e, a second bit line BL2e, and an upper conductive line UCLe.

The dummy pattern DPe may be formed to improve the uniformity in the fabrication process of the semiconductor device. In an implementation, the semiconductor device may not include the dummy pattern DPe.

In a semiconductor device, it may be possible to improve a degree of freedom of interconnection lines and a parasitic capacitance of the interconnection lines.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations and even initially be claimed as such, one or more features from a combination can in some cases be excised from the combination, and the combination may be directed to a subcombination or variation of a subcombination.

While example embodiments of the inventive concept have been particularly shown and described, it will be understood by one of ordinary skill in the art that variations in form and detail may be made therein without departing from the spirit and scope of the attached claims.

## Claims

1. A semiconductor device, comprising:
a first lower active contact;
a first source/drain pattern on the first lower active contact;
a second lower active contact;
a second source/drain pattern on the second lower active contact;
a lower conductive layer electrically connected to the first and second lower active contacts;
a third source/drain pattern and a fourth source/drain pattern between the first and second source/drain patterns;
a first upper active contact on the third source/drain pattern;
a second upper active contact on the fourth source/drain pattern; and
an upper conductive line electrically connected to the first and second upper active contacts,
wherein the first to fourth source/drain patterns, the first and second lower active contacts, and the first and second upper active contacts are disposed between the lower conductive layer and upper conductive line.

2. The semiconductor device of claim 1, wherein a distance between the first and second upper active contacts is smaller than a distance between the first and second lower active contacts.

3. The semiconductor device of claim 1, wherein the lower conductive layer comprises:
a first lower conductive portion overlapped with the first lower active contact;
a second lower conductive portion overlapped with the second lower active contact; and
a third lower conductive portion connecting the first and second lower conductive portions to each other,
wherein the upper conductive line is overlapped with the third lower conductive portion.

4. The semiconductor device of claim 3, wherein the upper conductive line is extended in a first direction, and
a length of the third lower conductive portion in the first direction is larger than a length of the first and second lower conductive portions in the first direction.

5. The semiconductor device of claim 3, wherein the lower conductive layer further comprises:
a fourth lower conductive portion connected to the third lower conductive portion; and
a fifth lower conductive portion connecting the second and fourth lower conductive portions to each other,
wherein the third and fifth lower conductive portions are spaced apart from each other, and
the second and fourth lower conductive portions are spaced apart from each other.

6. The semiconductor device of claim 5, further comprising a lower conductive pattern between the third and fifth lower conductive portions and between the second and fourth lower conductive portions,
wherein the lower conductive layer surrounds the lower conductive pattern.

7. The semiconductor device of claim 6, further comprising:
a lower gate contact on the lower conductive pattern; and
a gate electrode on the lower gate contact.

8. The semiconductor device of claim 1, further comprising:
a first gate electrode adjacent to the first source/drain pattern;
an upper gate contact in contact with an upper portion of the first gate electrode;
a second gate electrode adjacent to the fourth source/drain pattern; and
a lower gate contact in contact with a lower portion of the second gate electrode.

9. The semiconductor device of claim 8, further comprising:
a lower conductive pattern in contact with a bottom surface of the lower gate contact; and
an insulating pattern surrounding the lower conductive pattern,
wherein the lower conductive layer surrounds the insulating pattern and the lower conductive pattern.

10. The semiconductor device of claim 9, further comprising:
a word line connection pattern in contact with a bottom surface of the lower conductive pattern; and
a word line in contact with a bottom surface of the word line connection pattern.

11. The semiconductor device of claim 1, wherein the first, second, and fourth source/drain patterns have a first conductivity type, and
the third source/drain pattern has a second conductivity type different from the first conductivity type.

12. The semiconductor device of claim 1, further comprising:
a first gate electrode adjacent to the second and third source/drain patterns;
a fifth source/drain pattern adjacent to the first gate electrode; and
a third lower active contact in contact with a lower portion of the fifth source/drain pattern,
wherein the third lower active contact is in contact with the lower conductive layer.

13. The semiconductor device of claim 12, further comprising:
a sixth source/drain pattern, which is adjacent to the fifth source/drain pattern, with the first gate electrode interposed therebetween;
a second gate electrode adjacent to the sixth source/drain pattern; and
a read word line electrically connected to the second gate electrode.

14. The semiconductor device of claim 13, wherein the read word line is disposed at the same level as the upper conductive line.

15. The semiconductor device of claim 13, wherein the read word line is disposed at a level lower than the lower conductive layer.

## Amended claims

### Amended claims in accordance with Rule 137(2) EPC.

1. A semiconductor device, comprising:
a first lower active contact (LAC1);
a first source/drain pattern (SD1) on the first lower active contact (LAC1);
a second lower active contact (LAC2);
a second source/drain pattern (SD2) on the second lower active contact (LAC2);
a lower conductive layer (LCL) electrically connected to the first and second lower active contacts (LAC1, LAC2);
a third source/drain pattern (SD3) and a fourth source/drain pattern (SD4) between the first and second source/drain patterns (SD1, SD2);
a first upper active contact (UAC1) on the third source/drain pattern (SD3);
a second upper active contact (UAC2) on the fourth source/drain pattern (SD4); and
an upper conductive line (UCL1) electrically connected to the first and second upper active contacts (UAC1, UAC2),
a first gate electrode (GE4);
a lower gate contact (LGC) connected to a lower portion of the first gate electrode (GE4); and
wherein the first to fourth source/drain patterns (SD1, SD2, SD3, SD4), the first and second lower active contacts (LAC1, LAC2), and the first and second upper active contacts (UAC1, UAC2) are disposed between the lower conductive layer (LCL) and upper conductive line (UCL1),
**characterized in that** the semiconductor device further comprises:
a word line (WL1) electrically connected to the lower gate contact (LGC),
wherein the word line (WL1) is disposed at a level lower than the lower conductive layer (LCL), and
wherein the word line (WL1) is overlapped with the lower conductive layer (LCL).

2. The semiconductor device of claim 1, wherein a distance between the first and second upper active contacts (UAC1, UAC2) is smaller than a distance between the first and second lower active contacts (LAC1, LAC2).

3. The semiconductor device of claim 1, wherein the lower conductive layer (LCL) comprises:
a first lower conductive portion (LCL1) overlapped with the first lower active contact (LCL 1);
a second lower conductive portion (LCL2) overlapped with the second lower active contact (LCA2); and
a third lower conductive portion (LCL4) connecting the first and second lower conductive portions (LCL1, LCL2) to each other,
wherein the upper conductive line (UCL1) is overlapped with the third lower conductive portion (LCL4).

4. The semiconductor device of claim 3, wherein the upper conductive line (UCL1) is extended in a first direction (D2), and
a length of the third lower conductive portion (LCL4) in the first direction (D2) is larger than a length of the first and second lower conductive portions (LCL1, LCL2) in the first direction (D2).

5. The semiconductor device of claim 3, wherein the lower conductive layer (LCL) further comprises:
a fourth lower conductive portion (LCL3) connected to the third lower conductive portion (LCL4); and
a fifth lower conductive portion (LCL6) connecting the second and fourth lower conductive portions (LCL2, LCL3) to each other,
wherein the third and fifth lower conductive portions (LCL4, LCL6) are spaced apart from each other, and
the second and fourth lower conductive portions (LCL2, LCL3) are spaced apart from each other.

6. The semiconductor device of claim 5, further comprising a lower conductive pattern (LCP) between the third and fifth lower conductive portions (LCL4, LCL6) and between the second and fourth lower conductive portions (LCL2, LCL3),
wherein the lower conductive layer (LCL) surrounds the lower conductive pattern (LCP).

7. The semiconductor device of claim 6, wherein
the lower gate contact (LGC) is on the lower conductive pattern (LCP); and
the first gate electrode (GE4) is on the lower gate contact (LGC).

8. The semiconductor device of claim 1, further comprising:
a lower conductive pattern (LCP) in contact with a bottom surface of the lower gate contact (LGC); and
an insulating pattern (IP) surrounding the lower conductive pattern (LCP),
wherein the lower conductive layer (LCL) surrounds the insulating pattern (IP) and the lower conductive pattern (LCP).

9. The semiconductor device of claim 8, further comprising:
a word line connection pattern (WLC) in contact with a bottom surface of the lower conductive pattern (LCP); and
wherein the word line (WL1) is in contact with a bottom surface of the word line connection pattern (WLC).

10. The semiconductor device of claim 1, wherein the first and second source/drain patterns (SD1, SD2) have a first conductivity type, and
the third and fourth source/drain patterns (SD3, SD4) have a second conductivity type different from the first conductivity type.

11. The semiconductor device of claim 1, further comprising:
a second gate electrode (GE1d) adjacent to the second and fourth source/drain patterns (SD2, SD4);
a fifth source/drain pattern (SD1d) adjacent to the second gate electrode (GE1d); and
a third lower active contact (LACd) in contact with a lower portion of the fifth source/drain pattern (SD1d),
wherein the third lower active contact (LACd) is in contact with the lower conductive layer (LCL2d).

12. The semiconductor device of claim 11, further comprising:
a sixth source/drain pattern (SD2d), which is adjacent to the fifth source/drain pattern (SD1d), with the second gate electrode (GE1d) interposed therebetween;
a third gate electrode (GE2d) adjacent to the sixth source/drain pattern (SD2d); and
a read word line (RWLd) electrically connected to the third gate electrode (GE2d).

13. The semiconductor device of claim 12, wherein the read word line (RWLd, RWL2e) is disposed at the same level as the upper conductive line (UCLd, UCLe).

14. The semiconductor device of claim 12, wherein the read word line (RWLe) is disposed at a level lower than the lower conductive layer (LCLe).
